# EUROPEAN PATENT APPLICATION

(11) **EP 4 679 497 A1**
(43) Date of publication of application: **14.01.2026**
(21) Application number: 24770807.6
(22) Date of filing: 08.03.2024
(51) Int. Cl.: H01L 21/683, B32B 27/00, B32B 27/18, C08K 5/3492, C08L 83/04, C08L 83/10, C09J 183/04, C09J 201/00, H01L 21/304, H05K 3/00

(54) **LASER PEELING COMPOSITION, LAMINATE, AND PROCESSING METHOD FOR SUBSTRATE WITH CIRCUIT**

(30) Priority: 10.03.2023 JP 2023037942
(71) Applicant: SHIN-ETSU CHEMICAL CO., LTD., Tokyo 1000005 (JP)
(72) Inventor: SUGO Michihiro, Annaka-shi, Gunma 379-0224 (JP); YAMAKI Masahiro, Annaka-shi, Gunma 379-0224 (JP)
(74) Representative: Schicker, Silvia
(86) International application number: PCT/JP2024/009175
(87) International publication number: WO 2024/190701

(57) **Abstract**

The present invention is a laser release composition comprising a compound (I) having a hydroxyphenyltriazine skeleton with a maximum absorption wavelength (Amax) in a wavelength range of 300 nm to 500 nm. Thus, the present invention provides a laser release composition configured to facilitate bonding between a support and a substrate, enable a heavily stepped substrate to be formed with a uniform film thickness, exhibit high compatibility with steps of forming a TSV and forming a wiring on the back surface of a wafer, have excellent resistance to wafer thermal processing such as chemical vapor deposition (CVD), allow for facile peeling of the substrate from the support, and enable removal of resin without contaminating the substrate, thereby enhancing the productivity of thin substrates.

## Description

### TECHNICAL FIELD

The present invention relates to a laser release composition, a laminate using the same, and a method for processing a circuit substrate.

### BACKGROUND ART

Three-dimensional semiconductor packaging has become essential for accomplishing even higher density and higher capacity. A three-dimensional packaging technology is a semiconductor fabrication technology for thinning a semiconductor chip, and connecting the chip to another chip using a through silicon via (TSV) to form a multilayer. In order to realize this technology, a step of thinning a substrate configured to have a semiconductor circuit formed thereon by grinding a non-circuit-formed surface (also referred to as "back surface") of the substrate to form an electrode including a TSV on the back surface is required. In the step of grinding the back surface of a silicon substrate, a protective tape for the back surface is conventionally attached to a back side of the surface to be ground to prevent wafer breakage during grinding. However, this tape uses an organic resin film as a support base material, which has flexibility but inadequate strength and heat resistance. Thus, the tape is not suited to the steps of forming a TSV and forming a wiring layer on the back surface.

In this context, there has been proposed a system in which a semiconductor substrate is bonded to a support made of silicon, glass, or the like through an adhesive layer to sufficiently withstand the steps of grinding the back surface and forming a TSV or an electrode on the back surface. The important point here is the adhesive layer employed to bond the substrate to the support. The adhesive layer requires sufficient durability to bond the substrate to the support without gaps and to withstand subsequent steps, while finally allowing facile peeling of a thin wafer from the support. The adhesive layer, which is finally peeled off, is hence referred to as a "temporary adhesive layer" (or temporary adhesive agent layer) herein.

With respect to the conventionally known temporary adhesive layer and a method of peeling this layer, a technique of using a hydrocarbon based hot-melt compound as an adhesive to perform bonding and/or peeling in a heat-molten state has been proposed (Patent Document 1). This technique is simple because of control only by heat, but thermal stability is insufficient at a high temperature exceeding 200°C, and thus the applicable range is limited.

In addition, a technique of using a silicone pressure-sensitive adhesive as the temporary adhesive agent layer has been suggested (Patent Document 2). In this technique, an addition curable type silicone pressure-sensitive adhesive is used to bond the substrate to the support and in the peeling, the substrate is immersed in a chemical that dissolves or decomposes the silicone resin so that the substrate is separated from the support, therefore requiring a long time to peel off the substrate. For this reason, it has been difficult to apply this technique to the actual producing process.

On the other hand, another technique has also been suggested in which an adhesive including a light absorbing substance is irradiated with light having high intensity to decompose an adhesive agent layer to peel the adhesive agent layer from the support (Patent Document 3). This method is advantageous in that it takes shorter time to process each substrate in separating the substrate from the support. However, since a metal compound needs to be used to convert the delivered light into heat, metal contamination may occur. In addition, when the adhesive agent layer remaining on the substrate is removed using a solvent, the adhesive that has been decomposed is insoluble in the solvent and therefore the remaining adhesive may adhere to the substrate again to result in contamination.

### CITATION LIST

### PATENT LITERATURE

Patent Document 1: JP 2003-177528 A
Patent Document 2: WO 2015/072418 A1
Patent Document 3: JP 2013-534721 B

### SUMMARY OF INVENTION

### TECHNICAL PROBLEM

The present invention has been made in view of the above-described problems, and an object thereof is to provide a laser release composition configured to facilitate bonding between a support and a substrate, have excellent resistance to wafer thermal processing such as chemical vapor deposition (CVD), allow facile peeling of the substrate from the support, and enable removal of resin from the support without contaminating the substrate, thereby enhancing the productivity of thin substrates. Another object of the present invention is to provide a laminated substrate suitable for the production of a thin substrate using such a laser release composition, and a method for processing a circuit substrate using such a laser release composition.

### SOLUTION TO PROBLEM

To achieve the object, the present invention provides a laser release composition including a compound (I) having a hydroxyphenyltriazine skeleton with a maximum absorption wavelength (λmax) in a wavelength range of 300 nm to 500 nm.

Such a laser release composition facilitates bonding between a support and a substrate, and the laser release layer formed by curing has excellent resistance to wafer thermal processing such as chemical vapor deposition (CVD), allows for facile peeling of the substrate from the support through laser decomposition, and enables formation of resin without contaminating the substrate.

In this case, the laser release composition preferably further includes a compound (II) having an organopolysiloxane structure.

In this case, the laser release composition further contains a crosslinker and a catalyst and is preferably thermosetting.

With such a laser release composition, curing can be performed efficiently, particularly easily by thermal curing.

In the laser release composition of the present invention, a laser release layer having a thickness of 1 µm formed using the laser release composition preferably has a light transmittance of 20% or less at a wavelength of 340 nm to 360 nm.

If the laser release layer after curing has light shielding properties in the wavelength of 340 nm to 360 nm, it is more useful as a release composition using a laser.

In the laser release composition of the present invention, the compound (I) having a hydroxyphenyltriazine skeleton preferably has a structure (1) below: 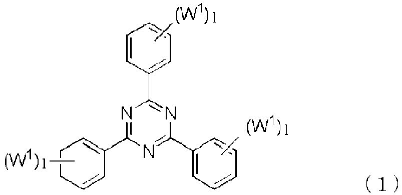 wherein W¹ is selected from the group consisting of a hydrogen atom, an alkyl group, an alkyl ether group, a hydroxyalkyl group, an alkyl ester group, and a hydroxy group, where at least one W¹ is a hydroxy group, and "l" represents 0 to 5, with at least one W¹ in the compound.

In this case, the compound (I) having a hydroxyphenyltriazine skeleton preferably has a structure (2) below: 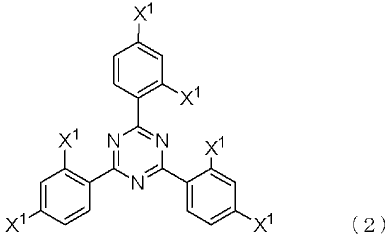 wherein X¹ is selected from the group consisting of a hydrogen atom, an alkyl group, an alkyl ether group, a hydroxyalkyl group, an alkyl ester group, and a hydroxy group, where at least one X¹ is a hydroxy group.

Such a laser release composition can more effectively achieve, for example, easy bonding between a support and a substrate, excellent resistance of the laser release layer formed by curing to wafer thermal processing such as chemical vapor deposition (CVD), facile peeling of the substrate from the support through laser decomposition, and removal of the resin without contaminating the substrate.

In addition, the compound (II) having an organopolysiloxane structure is preferably a siloxane bond-containing polymer having a repeating unit represented by general formula (3) and having a weight average molecular weight of 3,000 to 500,000: 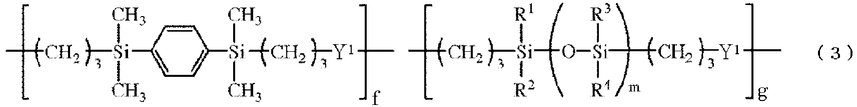 wherein R¹ to R⁴, which are the same or different, each represent a monovalent hydrocarbon group having 1 to 8 carbon atoms; "m" is an integer of 1 to 100, "g" is a positive number, and "f" is zero or a positive number, provided that f + g = 1; and Y¹ is a divalent organic group represented by general formula (4): 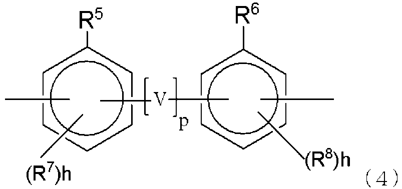 wherein V represents a divalent organic group selected from any of: 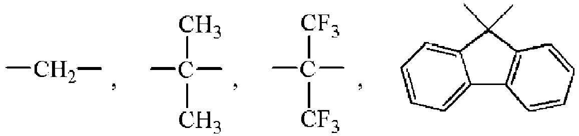 "p" is 0 or 1; R⁵ and R⁶ are each a hydrogen atom or a monovalent organic group represented by formula (5) below; R⁷ and R⁸ are each an alkyl group or alkoxy group having 1 to 4 carbon atoms, which are the same as or different from each other; and "h" is any one of 0, 1, and 2.

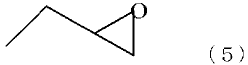

With such a laser release composition, curing can be performed efficiently and easily.

In the laser release composition of the present invention, the compound (II) having an organopolysiloxane structure is also preferably a siloxane-containing polyimide polymer having a repeating unit represented by general formula (6) and having a weight average molecular weight of 3,000 to 500,000: 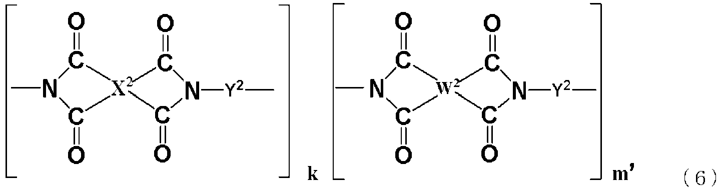 wherein "k" and "m'" are positive integers satisfying 0.01 ≤ k/(k + m') < 1, and X² is a tetravalent organic group represented by general formula (7): 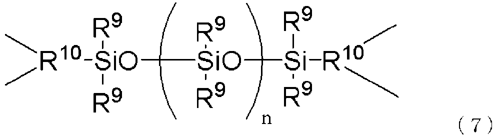 wherein R⁹ s are each independently a monovalent hydrocarbon group having 1 to 8 carbon atoms, R¹⁰s are each independently a trivalent organic group, and "n" is a number of 1 to 120 on average;

Y² is a divalent organic group, at least a part of which is represented by general formula (8): 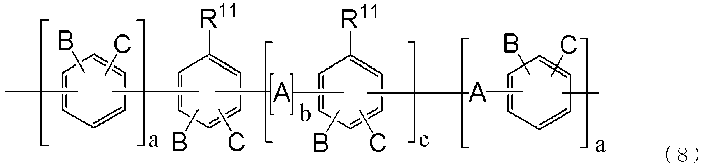 wherein A is a divalent organic group selected from any of: 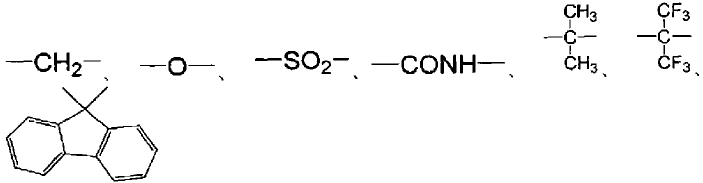 which are the same as or different from each other; B and C are each an alkyl group having 1 to 4 carbon atoms or a hydrogen atom, which are the same as or different from each other, "a" is 0 or 1, "b" is 0 or 1, and "c" is an integer of 0 to 10; R¹¹ in formula (8) is a monovalent group selected from organic groups containing a phenolic hydroxy group or an alcoholic hydroxy group; and W² is a tetravalent organic group other than X².

Even with such a laser release composition, curing can be performed efficiently and easily.

The present invention also provides a laminate including in order: a circuit substrate having a front surface on which a circuit is formed and a back surface to be processed; a curable silicone resin layer (A); a laser release layer formed of any of the above laser release compositions; and a support.

By using the laser release layer formed of the laser release composition of the present invention and the curable silicone resin layer (A) for bonding a circuit substrate and a support, such a laminate allows for removal of the laser release layer through laser decomposition, facilitates bonding between the circuit substrate and the support, enables a heavily stepped substrate to be formed with a uniform film thickness, exhibits high compatibility with steps of forming a TSV and forming a wiring on the wafer back surface, has excellent resistance to wafer thermal processing such as chemical vapor deposition (CVD), allows for facile peeling of the substrate from the support, and enables removal of resin without contaminating the substrate, thereby enhancing the productivity of processing the circuit substrate.

Moreover, in this laminate, the storage modulus at 25°C (E' at 25°C) of the curable silicone resin layer (A) is preferably 1 × 10⁶ to 1 × 10⁹ Pa, and a ratio (E' at 250°C)/(E' at 25°C) of the storage modulus at 25°C (E' at 25°C) to the storage modulus at 250°C (E' at 250°C) is preferably from 0.8 to 1.2.

In the case of using a curable silicone resin layer having such a storage modulus and storage modulus ratio, there is no risk of substrate misalignment during circuit substrate processing, and the substrate is stable during thermal processing.

In addition, the curable silicone resin (A) in this laminate is preferably a cured product of a composition including:
(A-1) an organopolysiloxane having two or more alkenyl groups per molecule in an amount of 100 parts by mass;
(A-2) an organohydrogenpolysiloxane having two or more silicon atom-bonded hydrogen atoms (SiH groups) per molecule, in such an amount that a molar ratio of the total of SiH groups in the component (A-2) to the total of alkenyl groups in the component (A-1) is from 0.3 to 10;
(A-3) a non-functional organopolysiloxane in an amount of 0.1 to 200 parts by mass; and
(A-4) a hydrosilylation reaction catalyst in an amount of 0.1 to 5,000 ppm in terms of metal atom amount based on the total mass of components (A-1), (A-2) and (A-3).

A laminate using such a curable silicone resin has excellent resistance to CVD.

In addition, the present invention provides a circuit substrate processing method, including providing the laminate and processing the circuit substrate, the method including, as a step of providing the laminate, the steps of:
(a-1) laminating an uncured composition layer of a curable silicone resin on a circuit substrate;
(a-2) laminating a laser release layer formed of the laser release composition according to any one of claims 1 to 8 on a support; and
(a-3) attaching the circuit substrate via the uncured composition layer of the curable silicone resin to the support via the laser release layer.

In this case, the method preferably includes the steps of:
(a) providing the laminate;
(b) thermally curing the uncured composition layer of the curable silicone resin;
(c) processing a back surface of the laminate;
(d) separating the support from the laminate by laser irradiation from a support side; and
(e) removing the curable silicone resin layer and the laser release layer from the separated laminate to take out only the circuit substrate.

Such a circuit substrate processing method enables a heavily stepped substrate to be formed with a uniform film thickness and has advantages of high compatibility with steps of forming a TSV and forming a wiring on the wafer back surface and excellent resistance to thermal processing such as CVD.

### ADVANTAGEOUS EFFECTS OF INVENTION

The laser release composition of the present invention facilitates bonding between a support and a substrate, has excellent resistance to wafer thermal processing such as chemical vapor deposition (CVD), allows for facile peeling of the substrate from the support, and enables removal of resin without contaminating the substrate, thereby enhancing the productivity of a thin substrate. In addition, a laminate including the laser release composition of the present invention and a curable silicone resin layer, which has been used for bonding between a circuit substrate and a support, allows for the removal of the laser release layer through laser decomposition, facilitates bonding between the circuit substrate and the support, and enables a heavily stepped substrate to be formed with a uniform film thickness. Moreover, such a laminate exhibits high compatibility with steps of forming a TSV and forming a wiring on the back surface of a wafer, has excellent resistance to wafer thermal processing such as chemical vapor deposition (CVD), allows for facile peeling of the substrate from the support, and enables removal of resin without contaminating the substrate, thereby enhancing the productivity of processing a circuit substrate.

### BRIEF DESCRIPTION OF DRAWING

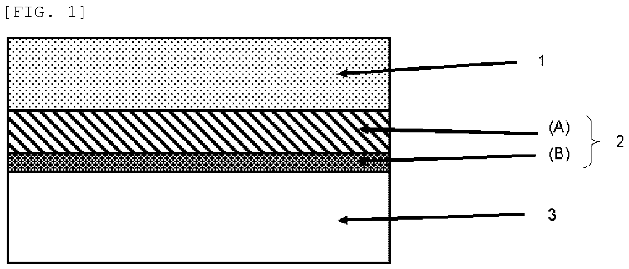

FIG. 1 is a cross-sectional view showing an example of a laminate in which a substrate and a support are bonded using the laser release composition of the present invention.

### DESCRIPTION OF EMBODIMENTS

As described above, there has been a demand for a laser release composition that facilitates bonding between a support and a substrate, has excellent resistance to wafer thermal processing such as chemical vapor deposition (CVD), allows for facile peeling of the substrate from the support, and enables removal of resin without contaminating the substrate, thereby enhancing the productivity of a thin substrate.

As a result of intensive studies to achieve the above objects, the present inventors have found that the objects can be attained by: bonding a support and a wafer (substrate) using a predetermined adhesive agent layer including a laser release composition to obtain a laminate; peeling off the support by decomposing the laser release layer with a laser; and subsequently peeling off to remove the remaining adhesive agent layer. Furthermore, they have found that a laser release composition including a compound (I) having a hydroxyphenyltriazine skeleton with a maximum absorption wavelength (λmax) in a wavelength range of 300 nm to 500 nm is optimal composition for forming such an adhesive agent layer, and have thus completed the present invention.

Hereinafter, the present invention is described in detail, but the present invention is not limited thereto. As used herein, the weight average molecular weight (Mw) and number average molecular weight (Mn) each refer to a value in terms of polystyrene obtained by gel permeation chromatography (GPC) using a calibration curve with standard polystyrene.

The present invention provides the following laser release composition, a laminate using the same, and a method for processing a circuit substrate.

In other words, the composition of the present invention is a laser release composition including a compound (1) having a hydroxyphenyltriazine skeleton with a maximum absorption wavelength (λmax) in a wavelength range of 300 nm to 500 nm.

Hereinafter, the present invention is described in detail, but the present invention is not limited thereto.

As shown in FIG. 1, the laminate of the present invention includes a first temporary adhesive layer (A) and a second temporary adhesive layer (B) that is different from the first temporary adhesive layer and forms a circuit substrate 1 having a front surface on which a circuit is formed and a back surface to be processed; a support 3 for supporting the circuit substrate 1 during processing thereof; and a temporary adhesive layer 2 interposed between the substrate 1 and the support 3. The temporary adhesive layer 2 is formed by laminating, in order, a curable silicone resin layer (A), a laser release layer (B) formed of the laser release composition of the present invention, and the support 2.

### [Support]

First, the support constituting the laminate is described. Examples of the support include a transparent substrate, a silicon wafer, and a ceramic substrate, and a transparent substrate is preferred from the viewpoint of transmissivity of a laser to be irradiated when the support is peeled off. The transparent substrate to be used is usually a glass substrate or a quartz substrate, and the thickness thereof is usually preferably from 300 to 1,000 µm, more preferably from 500 to 800 µm.

### [Wafer]

The wafer to be formed into the circuit substrate is usually a semiconductor wafer. Examples of the semiconductor wafer include a silicon wafer, a germanium wafer, a gallium-arsenic wafer, a gallium-phosphorus wafer, and a gallium-arsenic-aluminum wafer. Although not particularly limited, the thickness of the wafer is usually preferably from 600 to 800 µm, more preferably from 625 to 775 µm. A circuit substrate for forming a laminate is fabricated by processing such a wafer to form a circuit.

### [Laser Release Composition]

In the present invention, a compound having at least a hydroxyphenyltriazine skeleton is used as the compound to be used for the laser release composition. Specifically, the laser release composition of the present invention includes a compound (I) having a hydroxyphenyltriazine skeleton with a maximum absorption wavelength (λmax) in a wavelength range of 300 nm to 500 nm.

The compound (I) having a hydroxyphenyltriazine skeleton with a maximum absorption wavelength (λmax) in a wavelength range of 300 nm to 500 nm preferably has a structure (1) below: 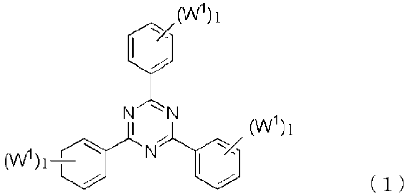 wherein W¹ is selected from the group consisting of a hydrogen atom, an alkyl group, an alkyl ether group, a hydroxyalkyl group, an alkyl ester group, and a hydroxy group, where at least one W¹ is a hydroxy group, and "l" represents 0 to 5, with at least one W¹ in the compound.

In particular, the structure of the compound (I) having a hydroxyphenyltriazine skeleton is preferably a structure (2) below: 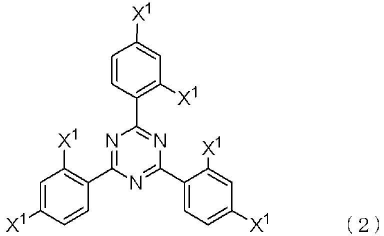 wherein X¹ is selected from the group consisting of a hydrogen atom, an alkyl group, an alkyl ether group, a hydroxyalkyl group, an alkyl ester group, and a hydroxy group, where at least one X¹ is a hydroxy group.

In the structure (2), specifically, the alkyl group used as X¹ is preferably a linear or branched alkyl group having 1 to 10 carbon atoms, which may be substituted or unsubstituted; the alkyl ether group used as X¹ is preferably a hydrocarbon group having 1 to 10 carbon atoms, which may be substituted or unsubstituted; and the alkyl hydroxy group used as X¹ is preferably an alkyl group having 1 to 10 carbon atoms with a hydroxy group substituted thereon, and preferably contains 1 to 4 hydroxy groups. In addition, the alkyl ester group used as X¹ may be an alkyl ester group (-COOR) derived from a carboxylic acid and having 1 to 10 carbon atoms. It should be noted that the X¹ groups in the formula of the structure (2) are the same as or different from each other, but at least one group within the compound is a hydroxy group. Among them, compounds having 1 to 6 hydroxy groups in the structure (2) are preferred, and those having 1 to 4 hydroxy groups are more preferred.

The maximum absorption wavelength (λmax) of the compound (I) having a hydroxyphenyltriazine skeleton of the present invention needs to fall within the wavelength range of 300 nm to 500 nm. This maximum absorption wavelength can be measured using an ultraviolet visible light spectrophotometer (UV-Vis meter).

In the present invention, the content of the compound (I) having a hydroxyphenyltriazine skeleton with a maximum absorption wavelength (λmax) in a wavelength range of 300 nm to 500 nm in the composition is preferably from 20 to 80 wt%, more preferably from 30 to 70 wt%.

Furthermore, in the present invention, the laser release composition preferably contains, as the component, a polyorganosiloxane resin or a polyimide polymer, or may also contain both the polyorganosiloxane resin and the polyimide polymer.

Among them, a case where the laser release composition contains a polyorganosiloxane resin is first described. In this case, the laser release composition preferably contains, in addition to the compound (I) having a hydroxyphenyltriazine skeleton, a compound (II) having an organopolysiloxane structure.

In this case, more specifically, the compound (II) having an organopolysiloxane structure is preferably a siloxane bond-containing polymer having a repeating unit represented by general formula (3) below and having a weight average molecular weight of 3,000 to 500,000: 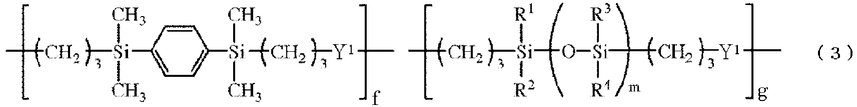 wherein R¹ to R⁴, which are the same or different, each represent a monovalent hydrocarbon group having 1 to 8 carbon atoms; "m" is an integer of 1 to 100; "g" is a positive number, and "f" is zero or a positive number, provided that f + g = 1; and Y¹ is a divalent organic group represented by general formula (4) below: 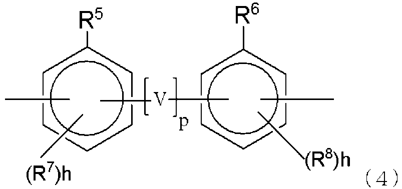 wherein V represents a divalent organic group selected from any of: 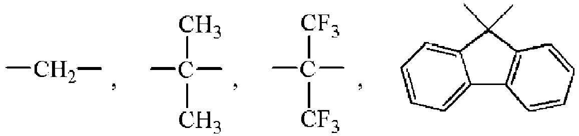 "p" is 0 or 1; R⁵ and R⁶ are each a hydrogen atom or a monovalent organic group represented by formula (5) below; R⁷ and R⁸ each represent an alkyl group or alkoxy group having 1 to 4 carbon atoms, which are the same as or different from each other; and "h" is any one of 0, 1, and 2.

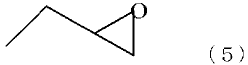

R¹ to R⁴ are preferably methyl groups or phenyl groups.

It should be noted that the weight average molecular weight of the organopolysiloxane (compound (II) having an organopolysiloxane structure) is preferably 3,000 to 500,000, and more preferably 5,000 to 300,000.

Next, a case where the laser release composition contains a polyimide polymer is described. In this case, the laser release composition further contains a polyimide polymer together with the compound (I) having a hydroxyphenyltriazine skeleton.

In this case, the polyimide polymer preferably includes a siloxane skeleton. More specifically, a siloxane-containing polyimide polymer having a repeating unit represented by general formula (6) below and having a weight average molecular weight of 3,000 to 500,000 is preferably used as the compound (II) having an organopolysiloxane structure: 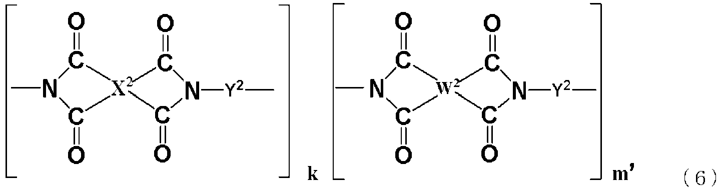 wherein "k" and "m'" are positive integers satisfying 0.01 ≤ k/(k + m') < 1, and X² is a tetravalent organic group represented by general formula (7) below: 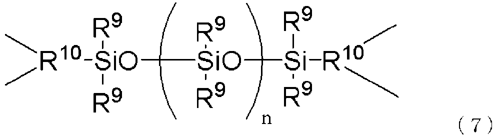 wherein R⁹s are each independently a monovalent hydrocarbon group having 1 to 8 carbon atoms, R¹⁰s are each independently a trivalent organic group, and "n" is a number of 1 to 120 on average.

Specifically, R⁹ is preferably a methyl group or a phenyl group. R¹⁰ is a trivalent organic group, preferably a hydrocarbon group having 1 to 10 carbon atoms.

Y² is a divalent organic group, at least a part of which is represented by general formula (8): 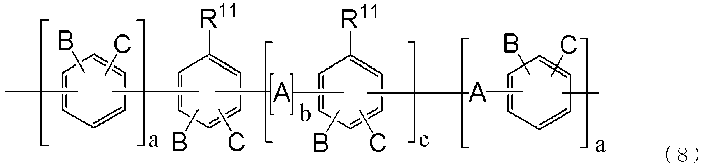 wherein A is a divalent organic group selected from any of: 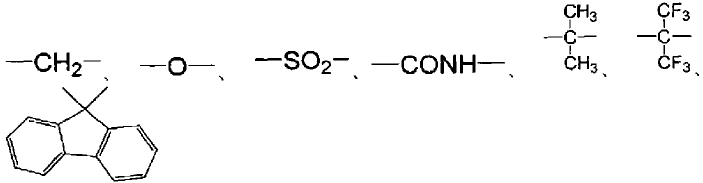 which are the same as or different from each other; B and C are each an alkyl group having 1 to 4 carbon atoms or a hydrogen atom, which are the same as or different from each other, "a" is 0 or 1, "b" is 0 or 1, and "c" is an integer of 0 to 10; R¹¹ in formula (8) is a monovalent group selected from organic groups containing a phenolic hydroxy group or an alcoholic hydroxy group; and W² is a tetravalent organic group other than X².

Preferably, W² is as follows.

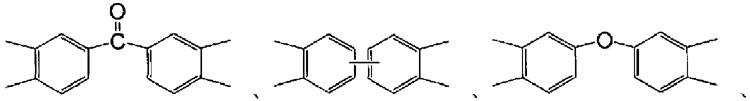

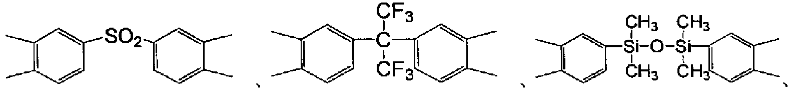

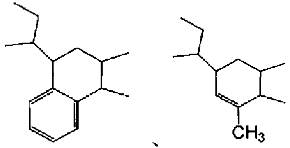

It should be noted that the weight average molecular weight of the polyimide polymer is preferably from 3,000 to 500,000, and more preferably from 5,000 to 300,000.

Furthermore, the laser release composition of the present invention preferably contains a crosslinker that crosslinks the resin through thermal reaction. As the crosslinker, epoxy compounds or epoxy resins having two or more functional groups in the molecule, amino resins such as methylol melamine, and the like are suitably used. In addition, it is preferable to further add a catalyst to the laser release composition of the present invention to accelerate the crosslinking reaction between the crosslinker and the polymer (compound (II) having an organopolysiloxane structure).

Examples of the epoxy compound or the epoxy resin include bi-, tri-, tetra- or higher polyfunctional epoxy resins, such as EOCN-1020 (see the formula below), EOCN-102S, XD-1000, NC-2000-L, EPPN-201, GAN, and NC6000, all manufactured by Nippon Kayaku Co., Ltd., and compounds represented by the following formulae.

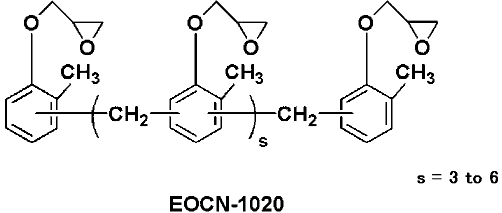

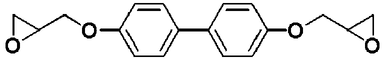

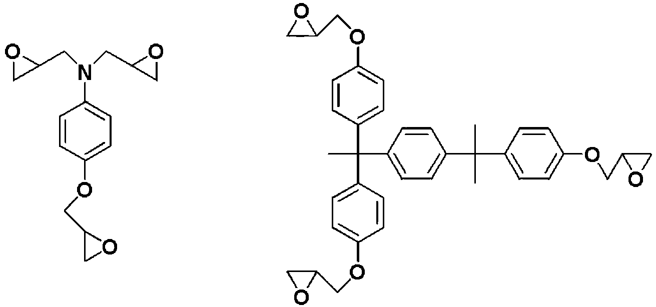

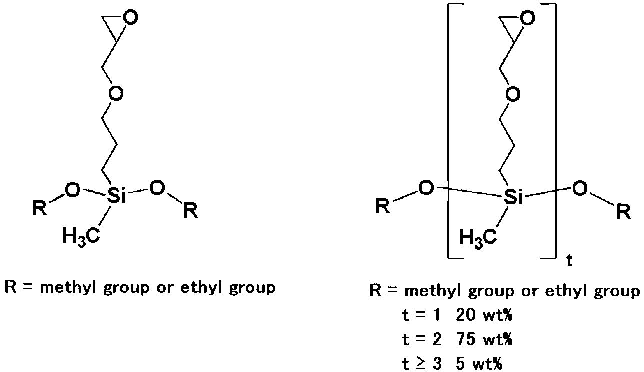

In the case of using the epoxy compound or the epoxy resin as the crosslinker, the formulation amount thereof is preferably from 0.1 to 50 parts by mass, more preferably from 0.1 to 30 parts by mass, still more preferably from 1 to 30 parts by mass, based on 100 parts by mass of the compound (II) having an organopolysiloxane structure. The crosslinker may be used singly or in combination with two or more thereof. If the formulation amount is within the above range, a sufficient crosslinking density can be obtained, allowing the resulting cured product to function sufficiently.

It should be noted that when the epoxy resin is used as the crosslinker, a curing accelerator is preferably added as a catalyst. The inclusion of the epoxy resin curing accelerator enables the curing reaction to proceed suitably and uniformly.

Examples of the epoxy resin curing accelerator include: imidazole compounds such as 2-methylimidazole, 2-ethyl imidazole, 2-ethyl-4-methyl imidazole, an ethyl isocyanate compound of these compounds, 2-phenyl imidazole, 2-phenyl-4-methyl imidazole, 2-phenyl-4-methyl-5-hydroxymethyl imidazole, and 2-phenyl-4,5-dihydroxymethyl imidazole; DBU compounds such as 1,8-diazabicyclo[5.4.0]undecene-7 (DBU), 1,5-diazabicyclo[4.3.0]nonene-5 (DBN), an organic acid salt of DBU, a phenolic resin salt of DBU, and a tetraphenylborate salt of a DBU derivative; triorganophosphines such as triphenylphosphine, tributyl phosphine, tris(p-methylphenyl)phosphine, tris(p-methoxyphenyl) phosphine, tris(p-ethoxyphenyl)phosphine, triphenylphosphine-triphenylborate, and tetraphenylphosphine-tetraphenylborate; and quaternary phosphonium salt, tertiary amines such as triethylene ammonium-triphenylborate, and tetraphenylboric acid salt thereof. The epoxy resin curing accelerator can be used singly or in combination with two or more thereof.

The formulation amount of the epoxy resin curing accelerator is preferably from 0.1 to 10 parts by mass, more preferably from 0.2 to 5 parts by mass, based on 100 parts by mass of the compound (II) having an organopolysiloxane structure.

Examples of the amino resin such as methylol melamine for use in the present invention include one or more compounds selected from the group consisting of amino condensates modified with formalin or formalin-alcohol and phenol compounds having two or more methylol groups or alkoxy methylol groups on average per molecule.

The amino resin has a weight average molecular weight Mw of preferably 150 to 10,000, more preferably 200 to 3,000. If the Mw is within the above range, sufficient curability is achieved so that the cured composition has high heat resistance.

Examples of the amino condensates modified with formalin or formalin-alcohol include melamine condensates modified with formalin or formalin-alcohol and urea condensates modified with formalin or formalin-alcohol.

The melamine condensate modified with formalin or formalin-alcohol can be prepared by, for example, modifying a melamine monomer with formalin into methylol according to a known method or modifying this product further into alkoxy with alcohol to form a modified melamine represented by the following formula. It should be noted that the alcohol is preferably a lower alcohol, for example, an alcohol having 1 to 4 carbon atoms. 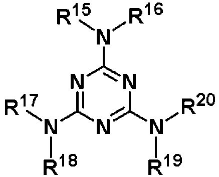 wherein, R¹⁵ to R²⁰ are each independently a methylol group, an alkoxymethyl group containing a linear, branched, or cyclic alkoxy group having 1 to 4 carbon atoms, or a hydrogen atom, at least one of which is a methylol group or an alkoxymethyl group.

Examples of the modified melamine include trimethoxymethyl monomethylol melamine, dimethoxymethyl monomethylol melamine, trimethylol melamine,
hexamethylol melamine, and hexamethoxymethylol melamine. Then, the modified melamine or a multimer thereof (e.g., an oligomer such as a dimer or a trimer) is subjected to addition polycondensation with formaldehyde according to a conventional method until a desired molecular weight is reached, thereby obtaining a melamine condensate modified with formalin or formalin-alcohol. It should be noted that at least one modified melamine condensate selected from the modified melamine and a condensate thereof can be used as a crosslinker.

The urea condensate modified with formalin or formalin-alcohol can be prepared by, for example, modifying a urea condensate having a desired molecular weight with formalin into methylol according to a known method or modifying this product further into alkoxy with alcohol.

Specific examples of the modified urea condensate include a methoxy methylated urea condensate, an ethoxy methylated urea condensate, and a propoxy methylated urea condensate. It should be noted that one or more of these modified urea condensates can be used.

Among these, examples of the phenol compound having, on average, two or more methylol groups or alkoxy methylol groups per molecule include (2-hydroxy-5-methyl)-1,3-benzenedimethanol and 2,2',6,6'-tetramethoxymethylbisphenol A.

These amino condensates or phenol compounds may be used singly or in combination with two or more thereof.

The formulation amount of the crosslinker is preferably from 0.1 to 50 parts by mass, more preferably from 1 to 30 parts by mass, based on 100 parts by mass of the compound (II) having an organopolysiloxane structure. In this range, the compound (II) is cured enough, allowing the resulting cured product to function sufficiently.

It should be noted that when the amino resin such as methylol melamine is used as the crosslinker, it is preferable to add a heat acid generator as the catalyst. Examples of this heat acid generator include, but are not particularly limited to, an ammonium salt represented by the following formula: 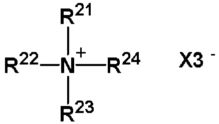 wherein R²¹ to R²⁴ each independently represent a hydrogen atom, a linear, branched, or cyclic alkyl group or oxoalkyl group having 1 to 12 carbon atoms, a linear, branched, or cyclic alkenyl group or oxoalkenyl group having 2 to 12 carbon atoms, an aryl group having 6 to 20 carbon atoms, or an aralkyl group or an aryloxoalkyl group having 7 to 12 carbon atoms, and some or all of the hydrogen atoms of these groups may be substituted with alkoxy groups; two selected from R²¹ to R²⁴ may form a ring together with a nitrogen atom bonded thereto, the ring being an aliphatic ring having 3 to 10 carbon atoms with the nitrogen atom in the formula in the ring, or a heteroaromatic ring having 5 to 10 carbon atoms with the nitrogen atom in the formula in the ring; and X3⁻ is a sulfonic acid, perfluoroalkyl imide acid, or perfluoroalkyl methide acid in which at least one of α-positions is fluorinated.

Specific examples of X3⁻ include: perfluoroalkane sulfonic acid anions such as triflate anion and nonaflate anion; sulfonate anions with at least one of α-positions fluoro-substituted; imide anions such as bis(trifluoromethylsulfonyl)imide anion,
bis(perfluoroethylsulfonyl)imide anion, and bis(perfluorobutylsulfonyl)imide anion; and methanide anions such as tris(trifluoromethylsulfonyl)methanide anion and tris(perfluoroethylsulfonyl)methanide anion.

The formulation amount of heat acid generator is preferably from 0.1 to 15 parts by mass, more preferably from 0.2 to 10 parts by mass, based on 100 parts by mass of the laser release composition of the present invention. In this range, the laser release composition is cured enough, and the storage stability of the laser release composition is also high.

The laser release composition of the present invention may contain a solvent. Examples of the solvent include: ketones such as cyclohexanone, cyclopentanone, and methyl-2-n-amyl ketone; alcohols such as 3-methoxy butanol, 3-methyl-3-methoxy butanol, 1-methoxy-2-propanol, and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, 3-methoxy methyl propionate, 3-ethoxy ethyl propionate, tert-butyl acetate, tert-butyl propionate, propylene glycol mono-tert-butyl ether acetate, and γ-butyrolactone. These solvents may be used singly or in combination with two or more thereof. The formulation amount of the solvent is preferably from 100 to 5,000 parts by mass, more preferably from 150 to 2,500 parts by mass, based on 100 parts by mass of the laser release composition of the present invention.

The laser release composition of the present invention may contain, for example, a surfactant or an antioxidant for enhancing the heat resistance, if necessary.

Examples of the surfactant include, but are not particularly limited to, nonion-based surfactants, such as polyoxyethylene alkyl ethers such as polyoxyethylene lauryl ether, polyoxyethylene stearyl ether, polyoxyethylene cetyl ether, and polyoxyethylene oleyl ether; polyoxyethylene alkyl aryl ethers such as polyoxyethylene octyl phenyl ether and polyoxyethylene nonylphenyl ether; polyoxyethylene polyoxypropylene block copolymers; sorbitan fatty acid esters such as sorbitan monolaurate, sorbitan monopalmitate, and sorbitan monostearate; polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, and the like; fluorochemical surfactants such as EFTOP (R) EF301, EF303, and EF352 (manufactured by Tochem Products Co., Ltd.), Megaface (R) F171, F172, and F173 (manufactured by DIC Corporation), Fluorad (R) FC430 and FC431 (manufactured by 3M), AsahiGuard AG710, Surflon (R) S-381, S-382, SC101, SC102, SC103, SC104, SC105, and SC106, and Surfynol (R) E1004, KH-10, KH-20, KH-30, and KH-40 (AGC Inc.); and organosiloxane polymer KP341 (manufactured by Shin-Etsu Chemical Co., Ltd.); and acrylic acid or methacrylic acid polyflow No. 75 and No. 95 (Kyoeisha Chemical Co., Ltd.). These surfactants may be used singly or in combination with two or more thereof.

The antioxidant is preferably at least one selected from the group consisting of a hindered phenol compound, a hindered amine compound, an organic phosphorous compound, and an organic sulfur compound.

Preferred examples of the hindered phenol compound include, but are not particularly limited to, the following compounds: 1,3,5-trimethyl-2,4,6-tris(3,5-di-tert-butyl-4-hydroxy-benzyl)benzene (product name: IRGANOX 1330); 2,6-di-tert-butyl-4-methylphenol (product name: Sumilizer BHT); 2,5-di-tert-butyl-hydroquinone (product name: Nocrac NS-7); 2,6-di-tert-butyl-4-ethylphenol (product name: Nocrac M-17); 2,5-di-tert-amylhydroquinone (product name: Nocrac DAH); 2,2'-methylenebis(4-methyl-6-tert-butylphenol) (product name: Nocrac NS-6); 3,5-di-tert-butyl-4-hydroxybenzylphosphonate-diethylester (product name: IRGANOX 1222); 4,4'-thiobis(3-methyl-6-tert-butylphenol) (product name: Nocrac 300); 2,2'-methylenebis(4-ethyl-6-tert-butylphenol) (product name: Nocrac NS-5); 4,4'-butylidenebis(3-methyl-6-tert-butylphenol) (product name: ADEKA STAB AO-40); 2-tert-butyl-6-(3-tert-butyl-2-hydroxy-5-methylbenzyl)-4-methylphenylacrylate (product name: Sumilizer GM); 2-[1-(2-hydroxy-3,5-di-tert-pentylphenyl)ethyl]-4,6-di-tert-pentylphenylacrylate (product name: Sumilizer GS); 2,2'-methylenebis[4-methyl-6-(α-methyl-cyclohexyl)phenol]; 4,4'-methylenebis(2,6-di-tert-butylphenol (product name: SEENOX 226M); 4,6-bis(octylthiomethyl)-o-cresol (product name: IRGANOX 1520L); 2,2'-ethylenebis(4,6-di-tertbutylphenol); octadecyl-3-(3,5-di-tert-butyl-4-hydroxyphenyl)-propionate (product name: IRGANOX 1076); 1,1,3-tris(2-methyl-4-hydroxy-5-tert-butylphenyl)butane (product name: ADEKA STAB AO-30); tetrakis[methylene-(3,5-di-tert-butyl-4-hydroxyhydrocinnamate)]methane (product name: ADEKA STAB AO-60); triethyleneglycolbis[3-(3-tert-butyl-5-methyl-4-hydroxyphenyl)propionate] (product name: IRGANOX 245); 2,4-bis(n-octylthio)-6-(4-hydroxy-3,5-di-tert-butylanilino)-1,3,5-triazine (product name: IRGANOX 565); N,N'-hexamethylenebis(3,5-di-tert-butyl-4-hydroxyhydrocinnamamide) (product name: IRGANOX 1098); 1,6-hexanediol-bis[3-(3,5-di-tert-butyl-4-hydroxyphenyl)propionate] (product name: IRGANOX 259); 2,2-thio-diethylene-bis[3-(3,5-di-tert-butyl-4-hydroxyphenyl)propionate] (product name: IRGANOX 1035); 3,9-bis[2-[3-(3-tert-butyl-4-hydroxy-5-methylphenyl)propionyloxy]1,1-dimethylethyl]-2,4,8,10-tetraoxaspiro[5.5]undecane (product name: Sumilizer GA-80); tris-(3,5-di-tert-butyl-4-hydroxybenzyl)isocyanurate (product name: IRGANOX 3114); bis(3,5-di-tert-butyl-4-hydroxybenzylphosphonic acid ethyl)calcium/polyethylene wax mixture (50:50) (product name: IRGANOX 1425WL); isooctyl-3-(3,5-di-tert-butyl-4-hydroxyphenyl)-propionate (product name: IRGANOX 1135); 4,4'-thiobis(6-tert-butyl-3-methylphenol) (product name: Sumilizer WX-R); and 6-[3-(3-tert-butyl-4-hydroxy-5-methylphenyl)-propoxy]-2,4,8,10-tetra-tert-butyldibenz[d,f][1,3,2]dioxaphosphepin (product name: Sumilizer GP).

Preferred examples of the hindered amine compound include, but are not particularly limited to, the following compounds: p,p'-dioctyldiphenylamine (product name: IRGANOX 5057); phenyl-α-naphthylamine (product name: Nocrac PA); poly(2,2,4-trimethyl-1,2-dihydroquinoline) (product name: Nocrac 224, 224-S); 6-ethoxy-2,2,4-trimethyl-1,2-dihydroquinoline (product name: Nocrac AW); N,N'-diphenyl-p-phenylene-diamine (product name: Nocrac DP); N,N'-di-β-naphthyl-p-phenylenediamine (product name: Nocrac White); N-phenyl-N'-isopropyl-p-phenylenediamine (product name: Nocrac 810NA); N,N'-diallyl-p-phenylenediamine (product name: Nonflex TP); 4,4'-(α,α-dimethylbenzyl)diphenylamine (product name: Nocrac CD); p,p-toluenesulfonylamino-diphenylamine (product name: Nocrac TD); N-phenyl-N'-(3-methacryloyloxy-2-hydroxypropyl)-p-phenylenediamine (product name: Nocrac G1); N-(1-methylheptyl)-N'-phenyl-p-phenylenediamine (product name: Ozonon 35); N,N'-di-sec-butyl-p-phenylenediamine (product name: Sumilizer BPA); N-phenyl-N'-1,3-dimethylbutyl-p-phenylenediamine (product name: Antigene 6C); alkylated diphenylamine (product name: Sumilizer 9A); succinic acid dimethyl-1-(2-hydroxyethyl)-4-hydroxy-2,2,6,6-tetramethylpiperidine polycondensate (product name: Tinuvin 622LD); poly[[6-(1,1,3,3-tetramethylbutyl)amino-1,3,5-triazine-2,4-diyl][(2,2,6,6-tetramethyl-4-piperidyl)imino]hexamethylene[(2,2,6,6-tetramethyl-4-piperidyl)imino]] (product name: CHIMASSORB 944); N,N'-bis(3-aminopropyl)ethylenediamine-2,4-bis[N-butyl-N-(1,2,2,6,6-pentamethyl-4-piperidyl)-amino]-6-chloro-1,3,5-triazine condensate (product name: CHIMASSORB 119FL); bis(1-octyloxy-2,2,6,6-tetramethyl-4-piperidyl)sebacate (product name: TINUVIN 123); bis(2,2,6,6-tetramethyl-4-piperidyl)sebacate (product name: TINUVIN 770); 2-(3,5-di-tert-butyl-4-hydroxybenzyl)-2-n-butylmalonic acid bis(1,2,2,6,6-pentamethyl-4-piperidyl) (product name: TINUVIN 144); bis(1,2,2,6,6-pentamethyl-4-piperidyl)sebacate (product name: TINUVIN 765); tetrakis(1,2,2,6,6-pentamethyl-4-piperidyl)1,2,3,4-butanetetra-carboxylate (product name: LA-57); tetrakis(2,2,6,6-tetramethyl-4-piperidyl)1,2,3,4-butanetetracarboxylate (product name: LA-52); an esterified product of a mixture of 1,2,3,4-butanetetracarboxylic acid, and 1,2,2,6,6-pentamethyl-4-piperidinol and 1-tridecanol (product name: LA-62); an esterified product of a mixture of 1,2,3,4-butanetetracarboxylic acid, and 2,2,6,6-tetramethyl-4-piperidinol and 1-tridecanol (product name: LA-67); an esterified product of a mixture of 1,2,3,4-butanetetracarboxylic acid, and 1,2,2,6,6-pentamethyl-4-piperidinol and 3,9-bis(2-hydroxy-1,1-dimethylethyl)-2,4,8,10-tetraoxaspiro[5.5]undecane (product name: LA-63P); an esterified product of a mixture of 1,2,3,4-butanetetracarboxylic acid, and 2,2,6,6-tetramethyl-4-piperidinol and 3,9-bis(2-hydroxy-1,1-dimethylethyl)-2,4,8,10-tetraoxaspiro[5.5]undecane (product name: LA-68LD); (2,2,6,6-tetramethylene-4-piperidyl)-2-propylenecarboxylate (product name: ADEKA STAB LA-82); and (1,2,2,6,6-pentamethyl-4-piperidyl)-2-propylenecarboxylate (product name: ADEKA STAB LA-87).

Preferred examples of the organic phosphorus compound include, but are not particularly limited to, the following compounds: bis(2,4-di-tert-butylphenyl) [1,1-biphenyl]-4,4'-diylbisphosphite; 9,10-dihydro-9-oxa-10-phosphaphenanthrene-10-oxide (product name: SANKO-HCA); triethylphosphite (product name: JP302); tri-n-butylphosphite (product name: JP304); triphenylphosphite (product name: ADEKA STAB TPP); diphenylmonooctylphosphite (product name: ADEKA STAB C); tri(p-cresyl)phosphite (product name: Chelex-PC); diphenylmonodecylphosphite (product name: ADEKA STAB 135A); dipheylmono(tridecyl)phosphite (product name: JPM313); tris(2-ethylhexyl)phosphite (product name: JP308); phenyldidecylphosphite (product name: ADEKA STAB 517); tridecylphosphite (product name: ADEKA STAB 3010); tetraphenyl dipropylene glycol diphosphite (product name: JPP100); bis(2,4-di-tert-butylphenyl)pentaerythritol diphosphite (product name: ADEKA STAB PEP-24G); tris(tridecyl)phosphite (product name: JP333E); bis(nonylphenyl)pentaerythritol diphosphite (product name: ADEKA STAB PEP-4C); bis(2,6-di-tert-butyl-4-methylphenyl)pentaerythritol diphosphite (product name: ADEKA STAB PEP-36); bis[2,4-di(1-phenylisopropyl)phenyl]pentaerythritol diphosphite (product name: ADEKA STAB PEP-45); trilauryltrithiophosphite (product name: JPS312); tris(2,4-di-tert-butylphenyl)phosphite (product name: IRGAFOS 168); tris(nonylphenyl)phosphite (product name: ADEKA STAB 1178); distearyl pentaerythritol diphosphite (product name: ADEKA STAB PEP-8); tris(mono, dinonylphenyl)phosphite (product name: ADEKA STAB 329K); trioleylphosphite (product name: Chelex-OL); tristearylphosphite (product name: JP318E); 4,4'-butylidenebis(3-methyl-6-tert-butylphenylditridecyl)phosphite (product name: JPH1200); tetra (C₁₂-C₁₅ mixed alkyl)-4,4'-isopropylidenediphenyldiphosphite (product name: ADEKA STAB 1500); tetra(tridecyl)-4,4'-butylidenebis(3-methyl-6-tert-butylphenol)diphosphite (product name: ADEKA STAB 260); hexa(tridecyl)-1,1,3-tris(2-methyl-5-tert-butyl-4-hydroxyphenyl)butane-triphosphite (product name: ADEKA STAB 522A); hydrogenated bisphenol A phosphite polymer (HBP); tetrakis(2,4-di-tert-butylphenyloxy)4,4'-biphenylene-di-phosphine (product name: P-EPQ); tetrakis(2,4-di-tert-butyl-5-methylphenyloxy)4,4'-biphenylene-di-phosphine (product name: GSY-101P); 2-[[2,4,8,10-tetrakis(1,1-dimethylethyl)-dibenzo[d,f][1,3,2]dioxaphosphepin-6-yl]oxy]-N,N-bis[2-[[2,4,8,10-tetrakis(1,1-dimethylethyl)dibenzo[d,f][1,3,2]dioxaphosphepin-6-yl]oxy]-ethyl]ethanamine (product name: IRGAFOS 12); and 2,2'-methylenebis(4,6-di-tert-butylphenyl)octylphosphite (product name: ADEKA STAB HP-10).

Preferred examples of the organic sulfur compound include, but are not particularly limited to, the following compounds: dilauryl-3,3'-thiodipropionate (product name: Sumilizer TPL-R); dimyristyl-3,3'-thiodipropionate (product name: Sumilizer TPM); distearyl-3,3'-thiodipropionate (product name: Sumilizer TPS); pentaerythritoltetrakis(3-laurylthiopropionate) (product name: Sumilizer TP-D); ditridecyl-3,3'-thiodipropionate (product name: Sumilizer TL); 2-mercaptobenzimidazole (product name: Sumilizer MB); ditridecyl-3,3'-thiodipropionate (product name: ADEKA STAB AO-503A); 1,3,5-tris-β-stearylthiopropionyloxyethylisocyanurate; 3,3'-thiobispropionate didodecylester (product name: IRGANOX PS 800FL); and 3,3'-thiobispropionate diocdecylester (product name: IRGANOX PS 802FL).

Of the antioxidants, tetrakis[methylene-(3,5-di-tert-butyl-4-hydroxyhydrocinnamate)]methane is particularly preferred. The amount of antioxidant added is preferably from 0.5 to 5 parts by mass, and more preferably from 1 to 3 parts by mass based on 100 parts by mass of the laser release composition (resin composition) of the present invention. In this range, the enough heat resistance effect can be achieved and the compatibility can be obtained. It should be noted that the antioxidants may be used singly or in combination with two or more thereof.

When the resin composition (laser release composition) is a solution, the resin composition I is applied to a support by such a method as spin coating, roll coating, die coating, printing, or dipping, then prebaking is performed at a temperature of preferably 80°C to 200°C, more preferably 100°C to 180°C, according to volatilization conditions of the solvent, to volatilize the solvent, whereby a resin composition layer (laser release layer) is formed.

On the other hand, when the resin composition (laser release composition) is a film-shaped composition, a resin composition layer (laser release layer) can be formed on a support by a lamination method.

The laser release resin composition layer (laser release layer) formed on the support is further cured by heating or the like to function as a resin layer. The curing by heating can be carried out using a hot plate or an oven normally under the conditions of 100°C to 350°C for 5 to 10 minutes, preferably 150°C to 300°C for 3 to 8 minutes. The curing reaction can also be achieved by forming a wafer laminate in an uncured state without curing the resin composition layer, then heating the laminate as a whole.

The film thickness of the resin layer (laser release layer) formed on the support is preferably from 0.1 to 50 µm, more preferably from 0.3 to 30 µm. If the film thickness is in this range, a sufficient light-shielding property is obtained, and flatness of the film is also good.

In the laser release composition of the present invention, a laser release layer having a thickness of 1 µm formed using the laser release composition preferably has a light transmittance of 20% or less at a wavelength of 340 nm to 360 nm. The lower limit is not particularly limited, but is about 3%. Such a light shielding property is more useful for peeling using a laser.

### [Curable Silicone Resin Layer (A)]

The resin to be formed on the wafer (circuit substrate 1 in Fig. 1) side is a curable silicone resin layer (A). The storage modulus at 25°C (E' at 25°C) of the curable silicone resin layer (A) is preferably 1 × 10⁶ to 1 × 10⁹ Pa, and the ratio (E' at 250°C) / (E' at 25°C) of the storage modulus at 25°C (E' at 25°C) to the storage modulus at 250°C (E' at 250°C) is preferably from 0.8 to 1.2.

As shown in FIG. 1, the curable silicone resin layer A is a resin layer in contact with the laser release resin layer (laser release layer) formed on the support 2 side of the wafer laminate, and is removed by peeling off after peeling of the support 2. The type of curable silicone resin layer A is not particularly limited, but when it is a thermosetting resin, it is preferably a cured product of a resin composition containing a resin having a siloxane skeleton in view of heat resistance and other properties. In particular, epoxy-modified silicone resins are preferred. Further, for the purpose of bonding dissimilar substrates such as the support and the silicon wafer, the storage modulus at 25°C (E' at 25°C) is preferably in the range of 1 × 10⁶ to 1 × 10⁹ Pa.

The storage modulus (E') means a storage modulus (E') at a certain temperature measured under a tensile condition in which the shape of the cured product of the resin composition has a shape of 0.5 mm in thickness and dimensions of 30 mm × 10 mm at a frequency of 1 Hz using a known dynamic viscoelasticity measuring device.

In the laminate of the present invention, the curable silicone resin (A) is preferably a cured product of a composition containing components (A-1) to (A-4):
(A-1) an organopolysiloxane having two or more alkenyl groups per molecule in an amount of 100 parts by mass;
(A-2) an organohydrogenpolysiloxane having two or more silicon atom-bonded hydrogen atoms (SiH groups) per molecule, in such an amount that a molar ratio of the total of SiH groups in the component (A-2) to the total of alkenyl groups in the component (A-1) is from 0.3 to 10;
(A-3) a non-functional organopolysiloxane in an amount of 0.1 to 200 parts by mass; and
(A-4) a hydrosilylation reaction catalyst in an amount of 0.1 to 5,000 ppm in terms of metal atom amount based on the total mass of components (A-1), (A-2) and (A-3).

Hereinafter, each component constituting the curable silicone resin is described.

### [Component (A-1)]

The component (A-1) is an organopolysiloxane having two or more alkenyl groups per molecule. Examples of the component (A-1) include a linear or branched diorganopolysiloxane containing two or more alkenyl groups per molecule and an organopolysiloxane of three-dimensional network structure containing two or more alkenyl groups per molecule and siloxane units (Q units) represented by SiO4/2 units. Of these, the diorganopolysiloxane or organopolysiloxane of three-dimensional network structure having an alkenyl group content of 0.6 to 9 mol% is preferred. As used herein, the alkenyl group content refers to a proportion (mol%) of the number of alkenyl groups to the number of silicon atoms in the molecule.

Examples of the organopolysiloxane include polymers having the following formula (A-11), (A-12) or (A-13), which may be used singly or in combination with two or more thereof.

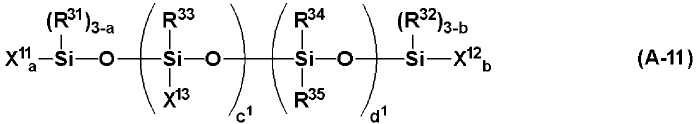

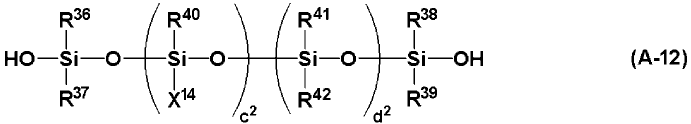

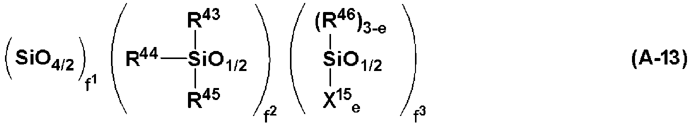

In formulae (A-11) to (A-13), R³¹ to R⁴⁶ are each independently a monovalent hydrocarbon group other than an aliphatic unsaturated hydrocarbon group. X¹¹ to X¹⁵ are each independently an alkenyl group-containing monovalent organic group.

In formula (A-11), "a" and "b" are each independently an integer of 0 to 3. In formulae (A-11) and (A-12), "c¹", "c²", "d¹", and "d²" are integers satisfying 0 ≤ c¹ ≤ 10, 2 ≤ c² ≤ 10, 0 ≤ d¹ ≤ 100, and 0 ≤ d² ≤ 100, provided that a + b + c¹ ≥ 2. "a", "b", "c¹", "c²", "d¹", and "d²" are preferably the combination of numbers such that the alkenyl group content is from 0.6 to 9 mol%.

In formula (A-13), "e" is an integer of 1 to 3. "f¹", "f²", and "f³" are such numbers that (f² + f³)/f¹ is from 0.3 to 3.0 and f³/(f¹ + f² + f³) is from 0.01 to 0.6.

The monovalent hydrocarbon group other than the aliphatic unsaturated hydrocarbon group preferably has 1 to 10 carbon atoms, and examples thereof include alkyl groups such as a methyl group, an ethyl group, an n-propyl group, an isopropyl group, an n-butyl group, a tert-butyl group, an n-pentyl group, and an n-hexyl group; cycloalkyl groups such as a cyclopentyl group and a cyclohexyl group; and aryl groups such as a phenyl group and a tolyl group. Of these groups, an alkyl group such as a methyl group or a phenyl group is preferred.

The alkenyl group-containing monovalent organic group preferably has 2 to 10 carbon atoms, and examples thereof include alkenyl groups such as a vinyl group, an allyl group, a hexenyl group, and an octenyl group; (meth)acryloyl alkyl groups such as an acryloyl propyl group, an acryloyl methyl group, and a methacryloyl propyl group; (meth)acryloxy alkyl groups such as an acryloxy propyl group, an acryloxy methyl group, a methacryloxy propyl group, and a methacryloxy methyl group; and alkenyl group-containing monovalent hydrocarbon groups such as a cyclohexenyl ethyl group and a vinyloxy propyl group. Of these groups, a vinyl group is preferred from the industrial point of view.

In formula (A-11), "a" and "b" are each independently an integer of 0 to 3. It is preferable that "a" be from 1 to 3 because a molecular chain end is capped with an alkenyl group, which is highly reactive and thus allows the reaction to be completed in a short time with a highly reactive alkenyl group at the molecular chain end. From the economy aspect, it is industrially preferable that "a" be 1. The alkenyl group-containing diorganopolysiloxane represented by formula (A-11) or (A-12) is preferably in the form of oil or raw rubber.

The organopolysiloxane represented by formula (A-13) has three-dimensional network structure and contains SiO_{4/2} units. In formula (A-13), "e" is each independently an integer of 1 to 3. From the economy aspect, it is industrially preferable that "e" be 1. In addition, the average value of e multiplied by f³/(f1 + f2 + f3) is from 0.02 to 1.5, more preferably from 0.03 to 1.0. The organopolysiloxane represented by formula (A-13) may be used as a solution dissolved in an organic solvent.

The organopolysiloxane serving as the component (A-1) preferably has a number average molecular weight (Mn) of 100 to 1,000,000, more preferably 1,000 to 100,000. If the Mn is in this range, the composition is satisfactory in working in terms of viscosity and processing in terms of storage elastic modulus after curing. As used herein, Mn is a measured value in terms of polystyrene determined by gel permeation chromatography using a toluene as a solvent.

The component (A-1) may be used singly or in combination with two or more thereof. Especially, an organopolysiloxane represented by formula (A-11) and an organopolysiloxane represented by formula (A-13) are preferably used in combination. At this point, the amount of the organopolysiloxane represented by formula (A-13) used is preferably from 1 to 1,000 parts by mass, more preferably from 10 to 500 parts by mass, based on 100 parts by mass of the organopolysiloxane represented by formula (A-11).

### [Component (A-2)]

The component (A-2), which serves as a crosslinker, is an organohydrogenpolysiloxane having at least two, preferably three or more silicon atom-bonded hydrogen atoms (SiH groups) per molecule. The organohydrogenpolysiloxane may be any of linear, branched, or cyclic, and may be used singly or in combination with two or more thereof.

The organohydrogenpolysiloxane serving as the component (A-2) has a viscosity at 25°C of preferably 1 to 5,000 mPa·s, more preferably 5 to 500 mPa·s. As used herein, the viscosity is a measured value at 25°C with a rotational viscometer.

The organohydrogenpolysiloxane serving as the component (A-2) has a Mn of preferably 100 to 100,000, more preferably 500 to 10,000. If the Mn is in this range, the composition is satisfactory in working in terms of viscosity and processing in terms of storage elastic modulus after curing.

The component (A-2) is blended in such an amount that a molar ratio (SiH groups/alkenyl groups) of the total of SiH groups in the component (A-2) to the total of alkenyl groups in the component (A-1) is preferably from 0.3 to 10, more preferably from 1.0 to 8.0. As long as the molar ratio is 0.3 or more, the problems such as a reduction in the crosslinking density and failure to cure a temporary adhesive agent layer do not arise. Furthermore, as long as the molar ratio is 10 or less, the crosslinking density does not become excessively high, a satisfactory pressure-sensitive adhesive force and tack are obtained, allowing for an extended usable time of a treating solution.

### [Component (A-3))]

The component (A-3) is a non-functional organopolysiloxane. As used herein, "non-functional" means that the molecule does not contain a reactive group such as an alkenyl group, a hydrogen atom, a hydroxy group, an alkoxy group, a halogen atom, or an epoxy group, which is bonded directly or via any group to a silicon atom.

Examples of such a non-functional
organopolysiloxane include an organopolysiloxane containing an unsubstituted or substituted monovalent hydrocarbon group having 1 to 12 carbon atoms, preferably 1 to 10 carbon atoms, other than an aliphatic unsaturated hydrocarbon group. Examples of such a monovalent hydrocarbon group include alkyl groups such as a methyl group, an ethyl group, a propyl group, a butyl group, a pentyl group, a hexyl group, and a heptyl group; cycloalkyl groups such as a cyclohexyl group; aryl groups such as a phenyl group, a tolyl group, a xylyl group, and a naphthyl group; and aralkyl groups such as a benzyl group and a phenethyl group. Some or all of the hydrogen atoms in these groups may be substituted with halogen atoms such as a chlorine atom, a fluorine atom, and a bromine atom, and examples of such groups include halogenated alkyl groups such as a chloromethyl group, a 3-chloropropyl group, and a 3,3,3-trifluoropropyl group. The monovalent hydrocarbon group is preferably an alkyl group or an aryl group, and more preferably a methyl group or a phenyl group.

The molecular structure of the component (A-3), which is a non-functional organopolysiloxane, is not particularly limited and may be any of linear, branched, cyclic, and the like, but a linear or branched organopolysiloxane is preferable. In particular, a linear or branched diorganopolysiloxane in which the main chain is basically composed of repeating dioragnosiloxane units and the molecular chain ends are capped with triorganosiloxy groups is preferable.

The non-functional organopolysiloxane of the component (A-3) preferably has a viscosity of 100 to 500,000 mPa·s, more preferably 200 to 100,000 mPa·s, at 25°C in a 30% by mass toluene solution, from the viewpoint of workability of the composition, coatability onto a substrate, mechanical properties of the cured product, and peelability from the support. Within this range, the molecular weight is appropriate, and therefore, the organopolysiloxane does not volatilize during curing by heating of the silicone resin composition, which would otherwise reduce the effects, nor does it cause wafer cracking during wafer thermal processes such as CVD, thus exhibiting favorable workability and coatability.

Examples of the linear non-functional organopolysiloxane include a dimethylsiloxane polymer having both molecular chain ends capped with trimethylsiloxy groups, a diphenylpolysiloxane having both molecular chain ends capped with trimethylsiloxy groups, a 3,3,3-trifluoropropylmethylsiloxane polymer having both molecular chain ends capped with trimethylsiloxy groups, a dimethylsiloxane/diphenylsiloxane copolymer having both molecular chain ends capped with trimethylsiloxy groups, a dimethylsiloxane/3,3,3-trifluoropropylmethyl copolymer having both molecular chain ends capped with trimethylsiloxy groups, a diphenylsiloxane/3,3,3-trifluoropropylmethyl copolymer having both molecular chain ends capped with trimethylsiloxy groups, a dimethylsiloxane/3,3,3-trifluoropropylmethylsiloxane/diphenylsiloxane copolymer having both molecular chain ends capped with trimethylsiloxy groups, a dimethylpolysiloxane having both molecular chain ends capped with triphenylsiloxy groups, a diphenylpolysiloxane having both molecular chain ends capped with triphenylsiloxy groups, and a dimethylsiloxane/diphenylsiloxane copolymer having both molecular chain ends capped with triphenylsiloxy groups.

Examples of the branched non-functional organopolysiloxane include, the following compounds: 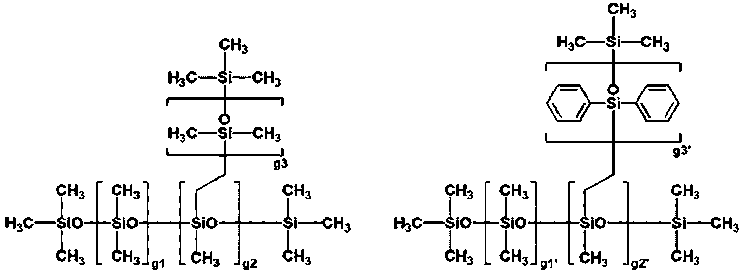 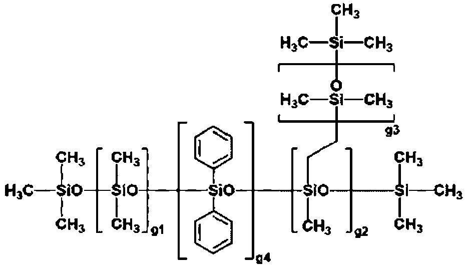 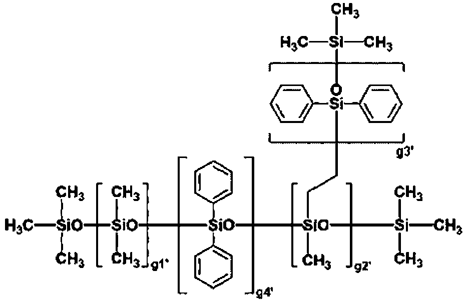 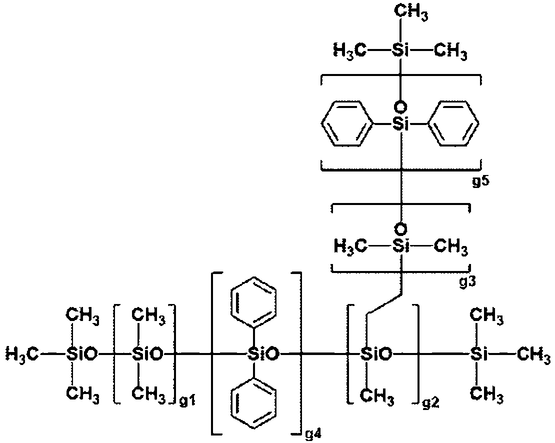 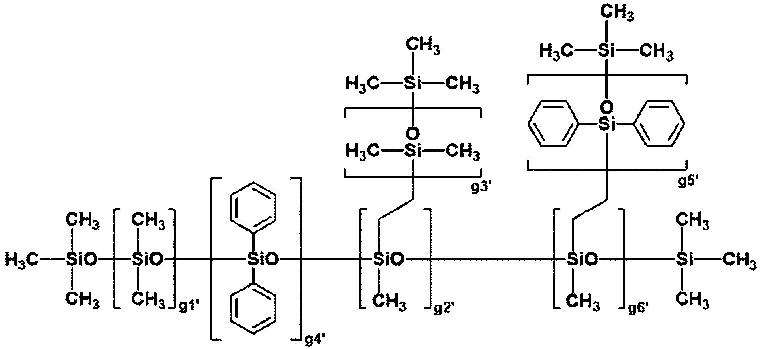 wherein g1, g2, g3, g4, g5, g1', g2', g3', g4', g5', and g6' are each independently an arbitrary integer such that the viscosity at 25°C of a 30% by mass toluene solution of the compound falls within the above range.

The formulation amount of the component (A-3), which is a non-functional organopolysiloxane, is 0.1 to 200 parts by mass, preferably 1 to 180 parts by mass, and more preferably 10 to 170 parts by mass, based on 100 parts by mass of the component (A-1). When the formulation amount of the component (A-3) is within the above range, the wafer can be easily peeled off from the support. The component (A-3), which is a non-functional organopolysiloxane, may be used singly or in combination with two or more thereof, and is preferably in the form of oil or raw rubber.

### [Component (A-4)]

The component (A-4) is a hydrosilylation reaction catalyst, preferably a platinum group metal-based hydrosilylation reaction catalyst. The component (A-4) serves as a catalyst that promotes the addition reaction between the alkenyl groups in the component (A-1) and the hydrosilyl group in the component (A-2). Since the hydrosilylation reaction catalyst is generally a compound of a noble metal and is expensive, a platinum or a platinum compound, which is relatively easily available, is often used.

Examples of the platinum compound include chloroplatinic acid, a complex of chloroplatinic acid and an olefin such as ethylene, a complex of chloroplatinic acid and an alcohol or vinylsiloxane, and metallic platinum supported on silica, alumina, carbon, or the like. As platinum group metal catalysts other than the platinum compound, rhodium-based, ruthenium-based, iridium-based, and palladium-based compounds are also known, and examples thereof include RhCl(PPh₃)₃, RhCl(CO) (PPh₃)₂, Ru₃(CO)₁₂, IrCl(CO) (PPh₃)₂, and Pd(PPh₃)₄. It should be noted that in the formula, "Ph" represents a phenyl group.

These catalysts, which are often solid, may be used in the solid form. However, a solution of chloroplatinic acid or a complex thereof in a suitable solvent is preferably used because the solution is compatible with the component (A-1) so that a cured product becomes more uniform.

The amount of component (A-4) added is an effective amount and is generally from 0.1 to 5,000 ppm, preferably from 1 to 1,000 ppm, in terms of metal atom amount based on the total mass of components (A-1), (A-2) and (A-3). When the amount is 0.1 ppm or more, the curability of the composition does not deteriorate, or the crosslinking density and the retention strength do not decrease. When the amount is 5,000 ppm or less, side reactions such as dehydrogenation during curing can be suppressed, allowing for an extended usable time of a treating solution.

### [Component (A-5)]

A thermosetting silicone resin composition may further contain, as the component (A-5), a reaction control agent. The reaction control agent is optionally added, if needed, during preparation of the composition or application to a substrate, in order to prevent thickening or gelation of the composition.

Examples of the reaction control agent include 3-methyl-1-butin-3-ol, 3-methyl-1-pentin-3-ol, 3,5-dimethyl-1-hexyn-3-ol, 1-ethynylcyclohexanol, 3-methyl-3-trimethylsiloxy-1-butin, 3-methyl-3-trimethylsiloxy-1-pentin, 3,5-dimethyl-3-trimethylsiloxy-1-hexyn, 1-ethynyl-1-trimethylsiloxycyclohexane, bis(2,2-dimethyl-3-butynyloxy)dimethylsilane, 1,3,5,7-tetramethyl-1,3,5,7-tetravinylcyclotetrasiloxane, and 1,1,3,3-tetramethyl-1,3-divinyldisiloxane. Of these, 1-ethynylcyclohexanol and 3-methyl-1-butin-3-ol are preferred.

When the thermosetting silicone resin composition contains component (A-5), the content thereof should be adjusted to the optimal amount according to the difference of the control capability determined by its chemical structure. In consideration of curability, storage stability, and post-curing physical properties, the content of the component (A-5) is preferably from 0.001 to 10 parts by mass, more preferably from 0.01 to 10 parts by mass, based on 100 parts by mass of the total of components (A-1), (A-2), and (A-3). Within this range, the composition exhibits a long usable time, excellent long-term storage stability, favorable curability, and good workability.

The thermosetting silicone resin composition may further contain an organopolysiloxane including R^{A}₃SiO_{0.3} units (wherein R^{A} is each independently an unsubstituted or substituted monovalent hydrocarbon group having 1 to 10 carbon atoms) and SiO2 units, with a molar ratio (R^{A}₃SiO_{0.5}/SiO₂) of the RA3Si00.5 units to the SiO2 units being from 0.3 to 1.8. The amount of such organopolysiloxane added is preferably from 0 to 500 parts by mass based on 100 parts by mass of the component (A-1).

To further enhance heat resistance, the curable silicone resin layer (A) may contain a filler such as silica in an amount of 50 parts by mass based on 100 parts by mass of the curable silicone resin layer (A).

The curable silicone resin layer (A) can be formed on the laser release layer (B) according to a method such as spin coating, roll coating, die coating, printing, or dipping. Alternatively, the laser release layer (B) can be formed on the curable silicone resin layer (A). Depending on the volatilization conditions of the solvent, it is preferable to perform a prebake at 60°C to 160°C for 1 to 4 minutes, more preferably at 80°C to 140°C for 2 to 4 minutes, to volatilize the solvent, whereby the curable silicone resin layer (A) is formed.

Regarding the curable silicone resin layer (A), it is preferable to form the curable silicone resin layer (A) by thermal curing, but the curable silicone resin layer (A) is preferably formed with a film thickness of preferably 1 to 200 µm, more preferably 5 to 150 µm when cured, depending on the stepped section on the wafer (circuit substrate) side. When the film thickness is within the above range, sufficient adhesion can be obtained during bonding, and the flatness of the attached wafer after bonding is also good.

Depending on the type of wafer (circuit substrate) to be used for the laminate, the heat resistance required for production may be relatively low. In this case, a thermoplastic resin can also be selected as the curable silicone resin layer (A).

### [Circuit Substrate Processing Method]

Next, a method for providing the laminate and processing the circuit substrate is described.

### [Method for Producing Laminate]

The step of providing the laminate of the present invention may include steps (a-1) to (a-3):
(a-1) laminating an uncured composition layer of a curable silicone resin on a circuit substrate;
(a-2) laminating a laser release layer formed of the laser release composition of the present invention on a support; and
(a-3) attaching the circuit substrate via the uncured composition layer of the curable silicone resin to the support via the laser release layer.

Using the laminate provided in this manner, the circuit substrate can be processed.

In addition, the circuit substrate processing method may include providing a laminate as step (a), including steps (a-1) to (a-3) above, and further include steps (b) to (e):
(b) thermally curing the uncured composition layer of the curable silicone resin;
(c) processing a back surface of the laminate;
(d) separating the support from the laminate by laser irradiation from a support side; and
(e) removing the curable silicone resin layer and the laser release layer from the separated laminate to take out only the circuit substrate.

### [Step (a-1)]

Step (a-1) involves laminating an uncured composition layer of a curable silicone resin on a circuit substrate, in other words, forming a curable silicone resin layer (A) on the circuit-formed surface of a wafer. When the uncured composition of the curable silicone resin is a solution, the curable silicone resin layer (A) can be formed by applying the uncured composition on the wafer by methods such as spin coating, roll coating, die coating, printing, and dipping, and then heating the uncured composition at 130°C to 190°C using a hot plate or an oven.

### [Step (a-2)]

Step (a-2) involves laminating a laser release layer formed of the laser release composition of the present invention on a support. When the laser release composition is a solution, the laser release composition is applied to the support by such a method as spin coating or roll coating, then prebaking is performed at a temperature of preferably 80°C to 200°C, more preferably 100°C to 180°C, according to volatilization conditions of the solvent, to volatilize the solvent, whereby a resin composition layer is formed. In addition, when the resin composition is a film-shaped composition, a resin composition layer can be formed on the support by a lamination method. It should be noted that the order of step (a-1) and step (a-2) may be reversed.

The release resin composition layer formed on the support may function as the resin layer by being cured by heating. The curing by heating can be carried out using a hot plate or an oven normally at a temperature of 100°C to 300°C, preferably 150°C to 300°C. The curing time is normally from 1 to 10 minutes, preferably from 2 to 8 minutes. The curing reaction can also be achieved by forming a wafer laminate in an uncured state without curing the resin composition layer, then heating the laminate as a whole.

### [Step (a-3)]

Step (a-3) involves attaching the circuit substrate via the uncured composition layer of the curable silicone resin to the support via the laser release layer. In this step, bonding can be performed under reduced pressure. The reduced pressure conditions are preferably 0.1 to 100 Pa, and more preferably 1 to 80 Pa. At this time, the substrate is uniformly pressure-bonded and bonded under reduced pressure in a temperature range of preferably 40°C to 240°C, and more preferably 60°C to 220°C.

As described above, the laminate is provided, and the circuit substrate can be processed (step a).

### [Step (b)]

Step (b) involves thermally curing the resin composition layer of the wafer laminate bonded in step (a) (step (a-3)) to form the resin layer A and bonding with the resin layer A. After the wafer laminate is formed, thermal curing is performed by heating at 120°C to 260°C, preferably at 150°C to 250°C for 1 minute to 4 hours, preferably 3 minutes to 2 hours.

### [Step (c)]

Step (c) involves processing a back surface of the laminate. Various processes used at the wafer level are included in this step. Examples thereof include wafer surface treatment, electrode formation, metal wiring formation, and protective film formation. Specific examples thereof include conventionally known processes such as CVD for wafer surface treatment, laser annealing, metal sputtering for the formation of electrodes and the like, vapor deposition, wet etching for etching a metal-sputtered layer, pattern formation by coating, exposure, and development of resist for use as a mask for metal wiring formation, resist stripping, dry etching, metal plating formation, organic film formation for surface protection, silicon etching for TSV formation, and oxide film formation on the surface of silicon. In such a process, it is desirable that the wafer workpiece has resistance over a wide range in a high temperature region up to about 400°C. In particular, it is preferable that the wafer workpiece has strength and life even at a temperature of 300°C or higher.

### [Step (d)]

Step (d) involves, from the thin wafer laminate processed in step (c), separating the support from the laminate in the laser release layer by laser irradiation from the support side of the laminate. This peeling step is generally carried out under a relatively low temperature condition of about room temperature, the step preferably including:
(d-1) adhering a dicing tape to the processed surface (back surface) of the processed wafer;
(d-2) sucking a dicing tape surface to a suction surface to vacuum; and
(d-3) peeling off the support from a thin wafer laminate, for example, by irradiation with a laser at a wavelength of 355 nm from the support side of the thin wafer laminate.

In this manner, the support can be easily peeled off from the wafer laminate, and the subsequent dicing step can be easily performed. It should be noted that as the dicing tape, a well-known tape using polyester, polyethylene film, or the like can be used.

### [Step (e)]

Step (e) involves removing the curable silicone resin layer and the laser release layer from the separated laminate to take out only the circuit substrate, that is, peeling off the laser release layer and the curable silicone resin layer remaining without being decomposed by laser from the processed circuit substrate by tape peeling or the like after peeling off the support in step (d).

This peeling step is generally carried out under relatively low-temperature conditions of approximately room temperature to 60°C. One example of a peeling method in step (e) includes horizontally fixing the wafer after step (d), bonding a peeling tape material onto the exposed undecomposed resin layer, and then peeling off the tape material by the peeling method to peel the laser release layer and the curable silicone resin layer from the processed circuit substrate.

Any tape capable of peeling may be used as the tape material, but tapes using a silicone pressure-sensitive adhesive are preferred. For example, polyester film pressure-sensitive tapes such as No. 646S and No. 648 manufactured by Teraoka Seisakusho Co., Ltd. are suitably used.

Furthermore, when the tape material is peeled by the peeling method, it is preferable to perform the peeling while heating the laminate, and the heating temperature is preferably from 30°C to 60°C, and more preferably from 35°C to 55°C. In this state where the laminate is heated, the adhesive force between the curable silicone resin layer and the circuit substrate is reduced, and the peeling can be performed more easily.

After performing step (e), it is preferable to carry out step (f) of removing the temporary adhesive layer remaining on the circuit-formed surface of the peeled wafer. On the circuit-formed surface of the wafer peeled through steps (d) and (e), a portion of the curable silicone resin layer may remain slightly, and such a curable silicone resin layer can be removed, for example, by cleaning the circuit substrate.

In step (f), a cleaning solution that dissolves the component of the curable silicone resin layer can be used, and specific examples thereof include pentane, hexane, cyclohexane, decane, isononane, p-menthane, pinene, isododecane, and limonene. These solvents may be used singly or in combination with two or more thereof. If it is difficult to remove, a base or an acid may be added to the solvent. Examples of the base that can be used include: amines such as ethanol amine, diethanol amine, triethanol amine, triethylamine, and ammonia; and ammonium salts such as tetramethyl ammonium hydroxide. Examples of the acid that can be used include organic acids such as acetic acid, oxalic acid, benzenesulfonic acid, and dodecylbenzenesulfonic acid. The addition amount is from 0.01 to 10% by mass, preferably from 0.1 to 5% by mass in terms of the concentration in the cleaning solution. To improve the removability of the residue, the existing surfactant may be added. The cleaning method may include cleaning with a paddle using the solution, cleaning using spraying, or immersion in a cleaning solution tank. The temperature is preferably from 10°C to 80°C, preferably from 15°C to 65°C, and if necessary, the curable silicone resin layer is dissolved in a dissolving solution thereof, finally washed with water or rinsed with an alcohol, followed by drying treatment, to obtain a thin wafer.

As described above, a thin wafer can ultimately be obtained by combining a support, a laser release layer, a resin layer, and a substrate having a circuit on the surface, peeling off the support, and further peeling off the resin layer by tape peeling.

### EXAMPLE

Hereinafter, the present invention is described in more detail with reference to Preparation Examples, Examples, and Comparative Examples, but the present invention is not limited to these Examples. It should be noted that in the following examples, "parts" refer to parts by mass. The weight average molecular weight (Mw) is a measured value in terms of polystyrene determined by GPC using THF as a solvent. Besides, an acid generator AG used in the following examples is as follows.

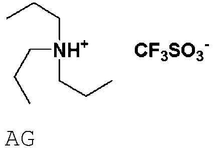

Besides, compounds (M-1) to (M-6) used in the following examples are as follows.

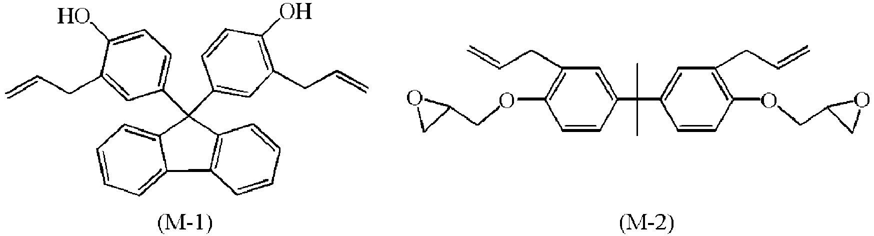

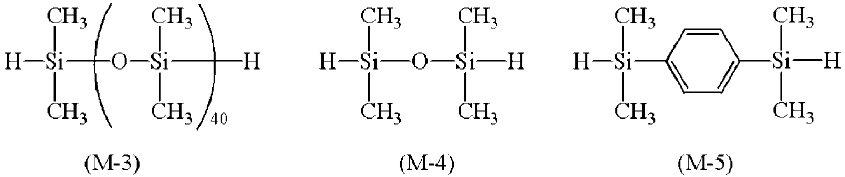

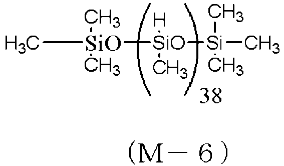

### [1] Preparation of Resin Solution

### [Preparation Example 1]

A flask equipped with a stirrer, a thermometer, a nitrogen purge system, and a reflux condenser was charged with 143.5 g of 9,9'-bis(3-allyl-4-hydroxyphenyl) fluorene (M-1), 98.3 g of organohydrogensiloxane represented by average structural formula (M-3), 700 g of toluene, and 0.1 g of chloroplatinic acid, and the mixture was heated at 80°C. Then, 58.3 g of 1,4-bis(dimethylsilyl)benzene (M-5) was added dropwise to the flask over 1 hour. At this time, the temperature inside the flask was increased to 85°C. After completion of dropwise addition, the mixture was aged at 80°C for 2 hours, toluene was then distilled off, and 300 g of cyclohexanone was added thereto to obtain a resin solution containing cyclohexanone as a solvent with a concentration of the resin solid of 50% by mass. When the molecular weight of the resin in the solution was measured by GPC, the weight average molecular weight was 34,000 in terms of polystyrene. This solution was designated as a siloxane-containing resin solution (B1).

### [Preparation Example 2]

A flask equipped with a stirrer, a thermometer, a nitrogen purge system, and a reflux condenser was charged with 102.8 g of diallyl diglycidyl bisphenol A (M-2), 49.1 g of organohydrogensiloxane represented by average structural formula (M-3), 450 g of toluene, and 0.06 g of chloroplatinic acid, and the mixture was heated at 80°C. Then, 42.4 g of 1,1,3,3-tetramethyldisiloxane (M-4) was added dropwise to the flask over 1 hour. At this time, the temperature inside the flask was increased to 85°C. After completion of dropwise addition, the mixture was aged at 80°C for 2 hours, toluene was then distilled off, and 190 g of cyclohexanone was added thereto to obtain a resin solution containing cyclohexanone as a solvent with a concentration of the resin solid of 50% by mass. When the molecular weight of the resin in the solution was measured by GPC, the weight average molecular weight was 41,000 in terms of polystyrene. This solution was designated as a siloxane-containing resin solution (B2).

### [Preparation Example 3]

A flask equipped with a stirrer, a thermometer, and a nitrogen purge system was charged with 50.2 g of 4,4'-oxydiphthalic dianhydride, 51.7 g of acid anhydride-modified siloxane having an average structure represented by formula (9) below, and 300 g of cyclohexanone. Subsequently, while adjusting the reaction system temperature not to exceed 50°C, 36.6 g of 2,2-bis(3-amino-4-hydroxyphenyl)hexafluoropropane was added to the flask. The mixture was then stirred at room temperature for 10 hours. Next, after attaching a reflux condenser equipped with a moisture trap to the flask, 100 g of toluene was added, the temperature was increased to 180°C and maintained for 6 hours, giving a brown solution. Gel permeation chromatography (GPC) analysis showed that the polymer had a number average molecular weight of 36,700. This solution was designated as a siloxane-containing resin solution (B3). Based on NMR analysis (NMR AVANCE III 400 MHz, manufactured by Bruker Biospin), B3 was found to have a structure represented by formula (6).

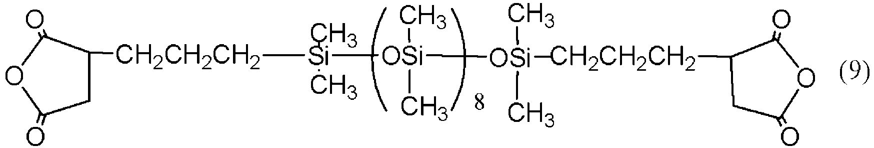

### [Preparation Example 4]

In 350 parts of cyclohexanone containing 0.1% by mass of FC-4430 (fluorosurfactant manufactured by 3M), 50 parts of hydroxyphenyltriazine compound (A1), 20 parts of resin solution B1, 1 part of acid generator AG, and 4 parts of NIKALAC Mw390 (manufactured by Sanwa Chemical Co., Ltd.) as a crosslinker were dissolved, and the mixture was filtered through a filter formed of fluorine resin of 0.1 µm to obtain a laser release composition C1.

It should be noted that the maximum absorption wavelength of (A1) was 349 nm. The light transmittance at a wavelength of 340 nm to 360 nm was 20% or less. The maximum absorption wavelength was measured using a UV-Vis spectrophotometer.

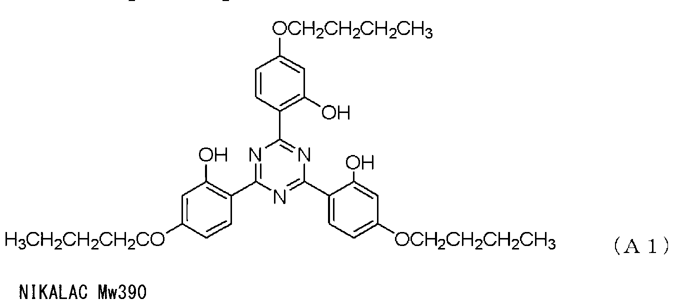

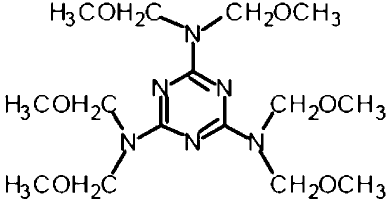

### [Preparation Example 5]

In 350 parts of cyclohexanone containing 0.1% by mass of FC-4430 (manufactured by 3M), 50 parts of hydroxyphenyltriazine compound (A2), 20 parts of resin solution B2, BSDM (bis(tert-butylsulfonyl)diazomethane, manufactured by FUJIFILM Wako Pure Chemical Corporation) as a curing catalyst, and 8 parts of epoxy crosslinker, EOCN-1020 (α-cresol novolac-type epoxy resin; epoxy equivalent: 194; manufactured by Nippon Kayaku Co., Ltd.) were dissolved, and the mixture was filtered through a filter formed of fluorine resin of 0.1 µm to obtain a laser release composition C2.

It should be noted that the maximum absorption wavelength of A2 was 341 nm. The light transmittance at a wavelength of 340 nm to 360 nm was 20% or less.

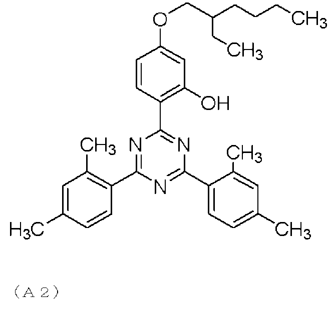

### [Preparation Example 6]

In 300 parts of cyclohexanone containing 0.1% by mass of FC-4430 (manufactured by 3M), 50 parts of hydroxyphenyltriazine compound (A1), 15 parts of resin solution B3, 1 part of acid generator AG, and 7 parts of NIKALAC Mw390 (manufactured by Sanwa Chemical Co., Ltd.) as a crosslinker were dissolved, and the mixture was filtered through a filter formed of fluorine resin of 0.1 µm to obtain a laser release composition C3.

### [Comparative Preparation Example 1]

A flask equipped with a stirrer, a thermometer, a nitrogen purge system, and a reflux condenser was charged with 143.5 g of 9,9'-bis(3-allyl-4-hydroxyphenyl) fluorene (M-1), 500 g of toluene, and 0.06 g of chloroplatinic acid, and the mixture was heated at 80°C. Then, 64.8 g of 1,4-bis(dimethylsilyl)benzene (M-5) was added dropwise to the flask over 1 hour. At this time, the temperature inside the flask was increased to 85°C. After completion of dropwise addition, the mixture was aged at 80°C for 2 hours, toluene was then distilled off, and 300 g of cyclohexanone was added thereto to obtain a resin solution containing cyclohexanone as a solvent with a concentration of the resin solid of 50% by mass. When the molecular weight of the resin in the solution was measured by GPC, the weight average molecular weight was 48,000 in terms of polystyrene. This solution was designated as a siloxane-free resin solution (B4).

### [Preparation Example 7]

To a solution containing 100 parts by mass of dimethylpolysiloxane with a Mn of 30,000 having 2.5 mol% of vinyl groups at a molecular side chain and 200 parts by mass of p-menthane, a solution containing 30 parts by mass of vinylmethylpolysiloxane with a Mn of 7,000 composed of 50 mol% of SiO_{4/2} units (Q units), 48 mol% of (CH₃) ₃SiO_{1/2} units (M units), and 2 mol% of (CH₂=CH) ₃SiO_{1/2} units (Vi units) and 70 parts by mass of p-menthane, a solution containing 30 parts by mass of organohydrogenpolysiloxane represented by M-6 with a Mn of 2,800 and 50 parts by mass of p-menthane, and 0.6 parts by mass of 1-ethynylcyclohexanol were added and mixed. In addition, 0.4 parts by mass of catalyst CAT-PL-5 (manufactured by Shin-Etsu Chemical Co., Ltd., platinum concentration: 1.0% by mass) was added thereto, and the mixture was then filtered through a membrane filter of 1 µm to prepare a thermosetting silicone resin solution D1. The viscosity of the resin solution D1 at 25°C was 2 Pa·s. The viscosity was measured using a rotational viscometer at 25°C. The storage modulus (storage modulus at 25°C (E' at 25°C)) of the resin solution D1 was 80 MPa.

### [Preparation Example 8]

To a solution containing 80 parts by mass of dimethyldiphenylpolysiloxane with a Mn of 50,000 having 2.5 mol% of vinyl groups at a molecular side chain and 3 mol% of phenyl groups at a molecular side chain and 200 parts by mass of p-menthane, a solution containing 50 parts by mass of vinylmethylpolysiloxane with a Mn of 7,000 composed of 50 mol% of SiO_{4/2} units (Q units), 48 mol% of (CH₃) ₃SiO_{1/2} units (M units), and 2 mol% of (CH₂=CH)₃SiO_{1/2} units (Vi units) and 70 parts by mass of p-menthane, a solution containing 30 parts by mass of organohydrogenpolysiloxane represented by M-6 with a Mn of 2,800 and 50 parts by mass of p-menthane, and 0.6 parts by mass of 1-ethynylcyclohexanol were added and mixed. In addition, 0.4 parts by mass of catalyst CAT-PL-5 (manufactured by Shin-Etsu Chemical Co., Ltd., platinum concentration: 1.0% by mass) was added thereto, and the mixture was then filtered through a membrane filter of 1 µm to prepare a thermosetting silicone resin solution D2. The viscosity of the resin solution D2 at 25°C was 3 Pa·s. The storage modulus (storage modulus at 25°C (E' at 25°C)) of the resin solution D2 was 150 MPa.

### [2] Fabrication and Evaluation of Thin Wafer

### [Examples 1 to 3]

On a glass plate having a diameter of 200 mm (thickness: 700 µm), the resin composition C1, C2, or C3 was applied by spin coating and heated on a hot plate at 100°C for 2 minutes and then at 250°C for 5 minutes to form a film of the material corresponding to the laser release layer with the film thickness shown in Table 1.

Furthermore, D1 or D2 was applied by spin coating to the copper post surface of a 200-mm diameter silicon wafer (thickness: 725 µm) on which copper posts having a height of 10 µm and a diameter of 40 µm were formed on the entire surface, or to the laser release layer, and then heated on a hot plate at 100°C for 2 minutes and at 150°C for 5 minutes, thereby forming a curable silicone resin layer with a film thickness shown in Table 1.

In a combination of glass plate-laser release layer and curable silicone resin layer-wafer, or glass plate-laser release layer-curable silicone resin layer and wafer, bonding was carried out in such a manner that the resin surfaces (i.e., the laser release layer and curable silicone resin layer) or the curable silicone resin layer and the copper post surface of the wafer were aligned and brought into contact. The bonding was performed under a reduced pressure of 1 Pa or less in a vacuum bonding device (EVG520IS, manufactured by EVG), under the conditions shown in Table 1, thereby fabricating a wafer laminate.

After that, the bonded substrate (laminate) was tested as described below. The results are shown in Table 1. It should be noted that the evaluations were performed in the following order.

### (1) Adhesion test

Wafers having a diameter of 200 mm were bonded together with the wafer bonding device EVG520IS manufactured by EVG. The bonding temperature was the values shown in Table 1, the pressure in the chamber in bonding was 1 Pa or less, and the load was 5 kn for B1 to B7, and 20 kn for B8. After the bonding, the temperature was decreased to room temperature, and the subsequent bonded state at the interface was observed with eyes and an optical microscope respectively. The wafer free of abnormalities such as bubbles at the interface was evaluated as good and shown as "Good", and the wafer with the abnormalities was evaluated as defective and shown as "Poor".

### (2) Back surface grinding resistance test

The back surface of the silicon wafer was ground by a grinder (DAG810, manufactured by DISCO Co., Ltd.) with a diamond grinding wheel. After the wafer was ground to a final substrate thickness of 50 µm, the presence or absence of abnormalities such as crack and peeling were checked with an optical microscope (100-folds). The wafer free of abnormalities was evaluated as good and shown as "Good", and the wafer with the abnormalities was evaluated as defective and shown as "Poor".

### (3) CVD resistance test

The laminate after the back surface of the silicon wafer was ground was introduced into the CVD apparatus and a SiO₂ film of 2 µm was formed in the experiment to check the presence or absence of abnormalities in the external appearance during the experiment. The laminate free of abnormalities in the external appearance was evaluated as good and shown as "Good", and an abnormality in the external appearance such as a void, wafer swelling, or a wafer damage was evaluated as defective and shown as "Poor". The CVD resistance test was performed under the following conditions:
Name of device: plasma CVD PD270STL (Samco Inc.) RF 500 W, internal pressure 40 Pa
TEOS (tetraethyl orthosilicate): O₂=20 sccm: 680 sccm

### (4) Support peelability test

The peelability of the support was evaluated by the following method: A dicing tape was first attached to a wafer side of the wafer laminate, which had been thinned to 50 µm following the CVD resistance test, using a dicing frame, and this dicing tape surface was set to a suction plate by vacuum suction. Thereafter, the entire surface was irradiated with a laser at a wavelength of 355 nm from the support side. A case where the support and the wafer of 50 µm could be peeled without cracking was shown as "Good", and a case where an abnormality such as cracking occurred was evaluated as defective and shown as "Poor".

### (5) Cleaning removability test

After completion of the peelability test in (4), the cleaning removability of B8 was evaluated using the solvent-based method outlined below. A 200 mm wafer (exposed to conditions for the CVD resistance test), mounted on a dicing frame via dicing tape, was placed on a spin coater with the resin layer B8 facing upward. As the cleaning solvent, 2% by mass of tetrabutylammonium fluoride was dissolved in dimethylpropionamide and then filtered through a filter of 1 µm to obtain a cleaning solution. Cleaning was performed by spraying for 5 minutes using the cleaning solution, followed by rinsing with isopropyl alcohol (IPA) while rotating the wafer. Subsequently, visual inspection was conducted to check for the presence or absence of any remaining resin layer. A case where no decomposed product of the polymer layer I or residue derived from the polymer layer II was observed was evaluated as good and shown as "Good", and a case where residue of the resin was observed was evaluated as defective and shown as "Poor".

### (6) Transmissivity test

On a glass substrate having a thickness of 700 µm, each of the adhesive composition solutions C1, C2, and C3 was applied with a film thickness of 0.3 µm by spin coating, heated on a hot plate at 180°C for 2 minutes and then heated at 250°C for 5 minutes to cure the compositions. Then, the transmittance (wavelength: 355 nm) was measured using the spectrophotometer (U-4100, manufactured by Hitachi High-Tech Science Corporation). A transmittance of 20% or less was evaluated as good and shown as "Good", and a transmittance of more than 20% was evaluated as defective and shown as "Poor".

**[Table 1]**

| | | Example 1 | Example 2 | Example 3 |
|---|---|---|---|---|
| Laser release layer | | C1 | C2 | C3 |
| Film thickness of laser release layer | | 0.4µm | 0.4µm | 0.4pm |
| Transmittance of laser release layer | | Good (5%) | Good (8%) | Good (7%) |
| Sx content in laser release layer [% by mass] | | 10 | 10 | 15 |
| Curable silicone resin layer | | D1 | D1 | D2 |
| Deposition direction of curable silicone resin layer (a: on silicon wafer) (b: on laser release layer) | | a | a | a |
| Film thickness of curable silicone resin layer | | 60µm | 60µm | 50µm |
| Bonding temperature | | 100°C | 100°C | 90°C |
| Adhesion | Visual inspection | Good | Good | Good |
| | Optical microscope | Good | Good | Good |
| Back surface grinding property | | Good | Good | Good |
| CVD resistance | | Good | Good | Good |
| Support peelability | | Good | Good | Good |
| Cleaning removability | | Good | Good | Good |

In Examples 1 to 3, the thermal processing (such as CVD) resistance was excellent, the substrate was easily peeled off from the support, the resin could be removed without contaminating the substrate, thereby enhancing the productivity of the thin substrate.

The present description includes the following embodiments.
[1]: A laser release composition comprising a compound (I) having a hydroxyphenyltriazine skeleton with a maximum absorption wavelength (λmax) in a wavelength range of 300 nm to 500 nm.
[2]: The laser release composition according to the above [1], further comprising a compound (II) having an organopolysiloxane structure.
[3]: The laser release composition according to the above [2], further comprising a crosslinker and a catalyst, the laser release composition being thermosetting.
[4]: The laser release composition according to any of the above [1] to [3], wherein a laser release layer having a thickness of 1 µm formed using the laser release composition has a light transmittance of 20% or less at a wavelength of 340 nm to 360 nm.
[5]: The laser release composition according to any of the above [1] to [4], wherein the compound (I) having a hydroxyphenyltriazine skeleton has a structure (1): 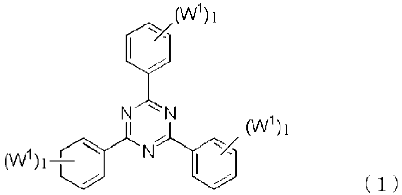 wherein W¹ is selected from the group consisting of a hydrogen atom, an alkyl group, an alkyl ether group, a hydroxyalkyl group, an alkyl ester group, and a hydroxy group, where at least one W¹ is a hydroxy group, and "l" represents 0 to 5, with at least one W¹ in the compound.
[6]: The laser release composition according to the above [5], wherein the compound (I) having a hydroxyphenyltriazine skeleton has a structure (2): 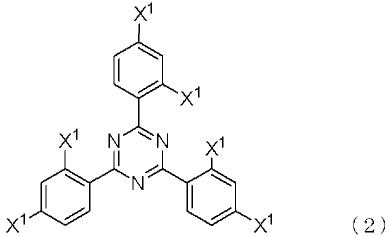 wherein X¹ is selected from the group consisting of a hydrogen atom, an alkyl group, an alkyl ether group, a hydroxyalkyl group, an alkyl ester group, and a hydroxy group, where at least one X¹ is a hydroxy group.
[7]: The laser release composition according to the above [2], wherein the compound (II) having an organopolysiloxane structure is a siloxane bond-containing polymer having a repeating unit represented by general formula (3) and having a weight average molecular weight of 3,000 to 500,000: 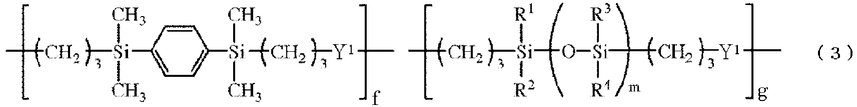
   wherein R¹ to R⁴, which are the same or different, each represent a monovalent hydrocarbon group having 1 to 8 carbon atoms; "m" is an integer of 1 to 100, "g" is a positive number, and "f" is zero or a positive number, provided that f + g = 1; and Y¹ is a divalent organic group represented by general formula (4): 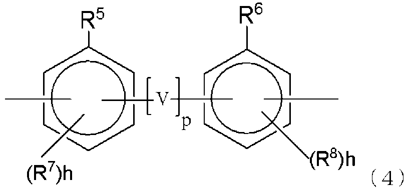
   wherein V represents a divalent organic group selected from any of: 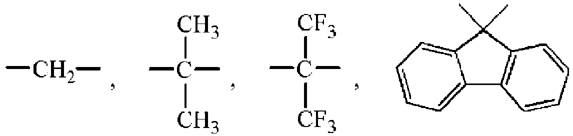 "p" is 0 or 1; R⁵ and R⁶ are each a hydrogen atom or a monovalent organic group represented by formula (5); R⁷ and R⁸ are each an alkyl group or alkoxy group having 1 to 4 carbon atoms, which are the same as or different from each other; and "h" is any one of 0, 1, and 2. 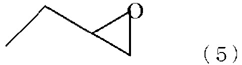
[8]: The laser release composition according to the above [2], wherein the compound (II) having an organopolysiloxane structure is a siloxane-containing polyimide polymer having a repeating unit represented by general formula (6) and having a weight average molecular weight of 3,000 to 500,000: 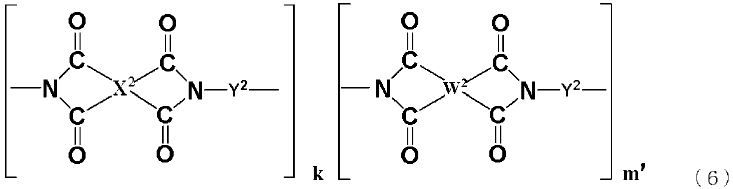
   wherein "k" and "m'" are positive integers satisfying 0.01 ≤ k/(k + m') < 1, and X² is a tetravalent organic group represented by general formula (7): 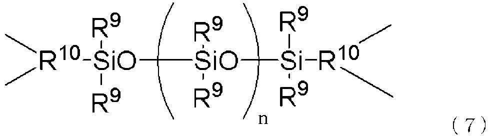
   wherein R⁹s are each independently a monovalent hydrocarbon group having 1 to 8 carbon atoms, R¹⁰s are each independently a trivalent organic group, and "n" is a number of 1 to 120 on average;
   Y² is a divalent organic group, at least a part of which is represented by general formula (8): 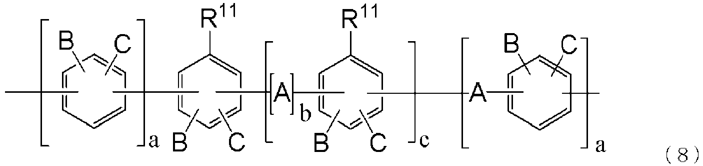
   wherein A is a divalent organic group selected from any of: 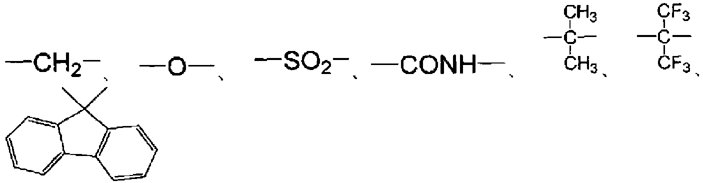 which are the same as or different from each other; B and C are each an alkyl group having 1 to 4 carbon atoms or a hydrogen atom, which are the same as or different from each other, "a" is 0 or 1, "b" is 0 or 1, and "c" is an integer of 0 to 10; R¹¹ in formula (8) is a monovalent group selected from organic groups containing a phenolic hydroxy group or an alcoholic hydroxy group; and W² is a tetravalent organic group other than X².
[9]: A laminate comprising in order:
   a circuit substrate having a front surface on which a circuit is formed and a back surface to be processed;
   a curable silicone resin layer (A);
   a laser release layer formed of the laser release composition according to any of the above [1] to [8]; and
   a support.
[10]: The laminate according to the above [8], wherein a storage modulus at 25°C (E' at 25°C) of the curable silicone resin layer (A) is 1 × 10⁶ to 1 × 10⁹ Pa, and a ratio (E' at 250°C)/(E' at 25°C) of the storage modulus at 25°C (E' at 25°C) to the storage modulus at 250°C (E' at 250°C) is from 0.8 to 1.2.
[11]: The laminate according to the above [9] or [10], wherein the curable silicone resin (A) is a cured product of a composition comprising:
   (A-1) an organopolysiloxane having two or more alkenyl groups per molecule in an amount of 100 parts by mass;
   (A-2) an organohydrogenpolysiloxane having two or more silicon atom-bonded hydrogen atoms (SiH groups) per molecule, in such an amount that a molar ratio of the total of SiH groups in the component (A-2) to the total of alkenyl groups in the component (A-1) is from 0.3 to 10;
   (A-3) a non-functional organopolysiloxane in an amount of 0.1 to 200 parts by mass; and
   (A-4) a hydrosilylation reaction catalyst in an amount of 0.1 to 5,000 ppm in terms of metal atom amount based on the total mass of components (A-1), (A-2) and (A-3).
[12]: A circuit substrate processing method, comprising providing the laminate according to any of the above [9] to [11] and processing the circuit substrate, the method comprising, as a step of providing the laminate, the steps of:
   (a-1) laminating an uncured composition layer of a curable silicone resin on a circuit substrate;
   (a-2) laminating a laser release layer formed of the laser release composition according to any of the above [1] to [8] on a support; and
   (a-3) attaching the circuit substrate via the uncured composition layer of the curable silicone resin to the support via the laser release layer.
[13]: The circuit substrate processing method according to the above [12], comprising the steps of:
   (a) providing the laminate;
   (b) thermally curing the uncured composition layer of the curable silicone resin;
   (c) processing a back surface of the laminate;
   (d) separating the support from the laminate by laser irradiation from a support side; and
   (e) removing the curable silicone resin layer and the laser release layer from the separated laminate to take out only the circuit substrate.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A laser release composition comprising a compound (I) having a hydroxyphenyltriazine skeleton with a maximum absorption wavelength (λmax) in a wavelength range of 300 nm to 500 nm.

2. The laser release composition according to claim 1, further comprising a compound (II) having an organopolysiloxane structure.

3. The laser release composition according to claim 2, further comprising a crosslinker and a catalyst, the laser release composition being thermosetting.

4. The laser release composition according to claim 1, wherein a laser release layer having a thickness of 1 µm formed using the laser release composition has a light transmittance of 20% or less at a wavelength of 340 nm to 360 nm.

5. The laser release composition according to claim 1, wherein the compound (I) having a hydroxyphenyltriazine skeleton has a structure (1): 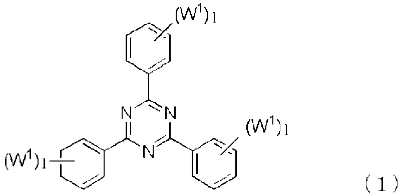 wherein W¹ is selected from the group consisting of a hydrogen atom, an alkyl group, an alkyl ether group, a hydroxyalkyl group, an alkyl ester group, and a hydroxy group, where at least one W¹ is a hydroxy group, and "l" represents 0 to 5, with at least one W¹ in the compound.

6. The laser release composition according to claim 5, wherein the compound (I) having a hydroxyphenyltriazine skeleton has a structure (2): 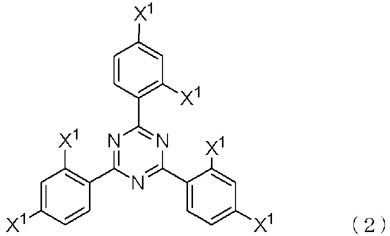 wherein X¹ is selected from the group consisting of a hydrogen atom, an alkyl group, an alkyl ether group, a hydroxyalkyl group, an alkyl ester group, and a hydroxy group, where at least one X¹ is a hydroxy group.

7. The laser release composition according to claim 2, wherein the compound (II) having an organopolysiloxane structure is a siloxane bond-containing polymer having a repeating unit represented by general formula (3) and having a weight average molecular weight of 3,000 to 500,000: 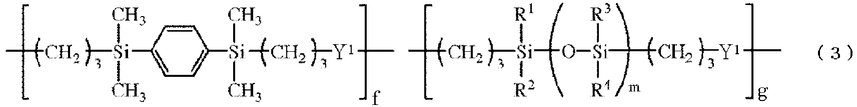
wherein R¹ to R⁴, which are the same or different, each represent a monovalent hydrocarbon group having 1 to 8 carbon atoms; "m" is an integer of 1 to 100, "g" is a positive number, and "f" is zero or a positive number, provided that f + g = 1; and Y¹ is a divalent organic group represented by general formula (4): 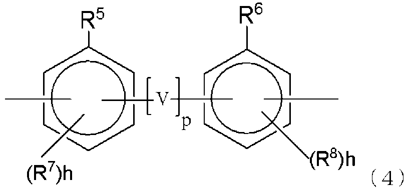
wherein V represents a divalent organic group selected from any of: 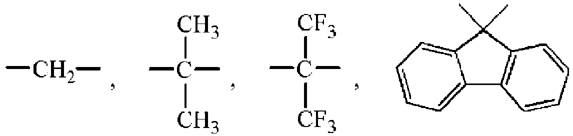 "p" is 0 or 1; R⁵ and R⁶ are each a hydrogen atom or a monovalent organic group represented by formula (5); R⁷ and R⁸ are each an alkyl group or alkoxy group having 1 to 4 carbon atoms, which are the same as or different from each other; and "h" is any one of 0, 1, and 2.

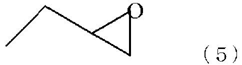

8. The laser release composition according to claim 2, wherein the compound (II) having an organopolysiloxane structure is a siloxane-containing polyimide polymer having a repeating unit represented by general formula (6) and having a weight average molecular weight of 3,000 to 500,000: 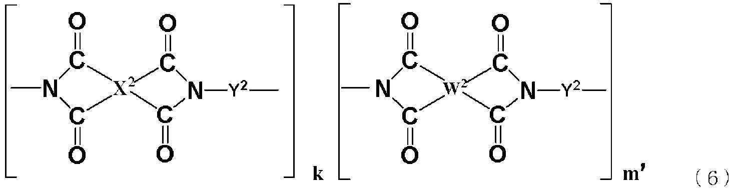
wherein "k" and "m'" are positive integers satisfying 0.01 ≤ k/(k + m') < 1, and X² is a tetravalent organic group represented by general formula (7): 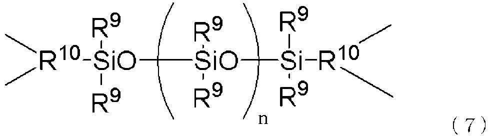
wherein R⁹s are each independently a monovalent hydrocarbon group having 1 to 8 carbon atoms, R¹⁰s are each independently a trivalent organic group, and "n" is a number of 1 to 120 on average;
Y² is a divalent organic group, at least a part of which is represented by general formula (8): 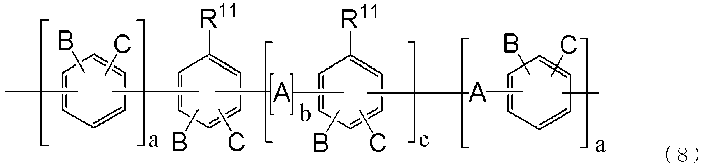 wherein A is a divalent organic group selected from any of: 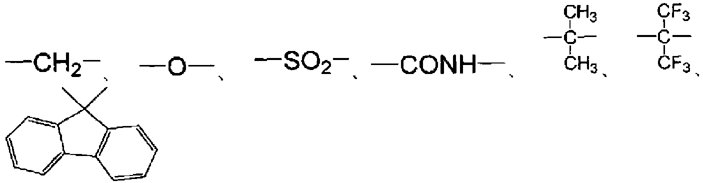 which are the same as or different from each other;
B and C are each an alkyl group having 1 to 4 carbon atoms or a hydrogen atom, which are the same as or different from each other, "a" is 0 or 1, "b" is 0 or 1, and "c" is an integer of 0 to 10; R¹¹ in formula (8) is a monovalent group selected from organic groups containing a phenolic hydroxy group or an alcoholic hydroxy group; and W² is a tetravalent organic group other than X².

9. A laminate comprising in order:
a circuit substrate having a front surface on which a circuit is formed and a back surface to be processed;
a curable silicone resin layer (A);
a laser release layer formed of the laser release composition according to any one of claims 1 to 8; and
a support.

10. The laminate according to claim 9, wherein a storage modulus at 25°C (E' at 25°C) of the curable silicone resin layer (A) is 1 × 10⁶ to 1 × 10⁹ Pa, and a ratio (E' at 250°C)/(E' at 25°C) of the storage modulus at 25°C (E' at 25°C) to the storage modulus at 250°C (E' at 250°C) is from 0.8 to 1.2.

11. The laminate according to claim 9, wherein the curable silicone resin (A) is a cured product of a composition comprising:
(A-1) an organopolysiloxane having two or more alkenyl groups per molecule in an amount of 100 parts by mass;
(A-2) an organohydrogenpolysiloxane having two or more silicon atom-bonded hydrogen atoms (SiH groups) per molecule, in such an amount that a molar ratio of the total of SiH groups in the component (A-2) to the total of alkenyl groups in the component (A-1) is from 0.3 to 10;
(A-3) a non-functional organopolysiloxane in an amount of 0.1 to 200 parts by mass; and
(A-4) a hydrosilylation reaction catalyst in an amount of 0.1 to 5,000 ppm in terms of metal atom amount based on the total mass of components (A-1), (A-2) and (A-3).

12. A circuit substrate processing method, comprising providing the laminate according to claim 9 and processing the circuit substrate, the method comprising, as a step of providing the laminate, the steps of:
(a-1) laminating an uncured composition layer of a curable silicone resin on a circuit substrate;
(a-2) laminating a laser release layer formed of the laser release composition according to any one of claims 1 to 8 on a support; and
(a-3) attaching the circuit substrate via the uncured composition layer of the curable silicone resin to the support via the laser release layer.

13. The circuit substrate processing method according to claim 12, comprising the steps of:
(a) providing the laminate;
(b) thermally curing the uncured composition layer of the curable silicone resin;
(c) processing a back surface of the laminate;
(d) separating the support from the laminate by laser irradiation from a support side; and
(e) removing the curable silicone resin layer and the laser release layer from the separated laminate to take out only the circuit substrate.
